# EUROPEAN PATENT APPLICATION

(11) **EP 4 683 466 A1**
(43) Date of publication of application: **21.01.2026**
(21) Application number: 25188424.3
(22) Date of filing: 09.07.2025
(51) Int. Cl.: H10H 29/01, H01L 23/00, B23K 26/066

(54) **MANUFACTURING DEVICE AND MANUFACTURING METHOD FOR DISPLAY PANEL**

(30) Priority: 16.07.2024 KR 20240093677
(71) Applicant: Samsung Display Co., Ltd., Yongin-si, Gyeonggi-do 17113 (KR)
(72) Inventor: Han, Jeong Won, Yongin-si, Gyeonggi-do (KR)
(74) Representative: Gulde & Partner

(57) **Abstract**

A manufacturing device of a display panel includes: a support portion (200) on which a display substrate (20) is mounted, a mask member (310) disposed on a front surface of the support portion (200) and defining first openings (312-OS) corresponding to a transmission area of a laser light, a support member (380) disposed on the display substrate (20) and defining a plurality of second openings (380-OS) formed in an area corresponding to donor substrates (TSUB) disposed on the display substrate (20), respectively, a pressing portion (300) including a pressing member (350) for pressing the support member (380) and the donor substrates (TSUB) disposed on the display substrate (20), and a laser irradiation portion (500) disposed on an upper portion of the mask member (310) for irradiating the laser light to light emitting elements (LE) of the donor substrates (TSUB). The support member (380) has a height (20-h) equal to a sum of a thickness (T-h) of each of the donor substrates (TSUB) and a height (L-h) of each of the light emitting elements (LE).

## Description

### BACKGROUND

### 1. Field

The present disclosure relates to a manufacturing device and a manufacturing method for a display panel.

### 2. Description of the Related Art

A micro light-emitting diode (LED) is an ultra-small inorganic light emitting material or element that emits light on its own without a backlight. Specifically, micro LEDs are about one-tenth the length and one-hundredth the area of organic light emitting diode chips. In one example, micro LED may refer to an ultra-small LED whose width, length, and height in the range of about 10 micrometers (µm) to 100 µm.

Micro LED may be manufactured by growing a plurality of chips on a growth substrate such as a wafer through an epi process or the like. The micro LEDs manufactured in this way are usually transferred to a donor substrate and then transferred to a target substrate that may be used as a display module.

The transfer process of the micro LEDs may use a laser transfer method that transfers the micro LEDs from the donor substrate to the target substrate by irradiating a laser light on the back of the donor substrate (a plurality of micro LEDs are arranged on the front of the relay substrate).

In the conventional laser transfer method, a pressing member that transmits the laser is adopted to pressurize the donor substrate while the laser is transmitted. At this time, there is a problem that the pressing member was bent due to the temperature and pressurizing force of the laser.

### SUMMARY

An object of the present disclosure is to provide a manufacturing device for a display panel with increased uniformity of the pressurizing force generated by the pressurizing of the laser light transmitting member.

However, aspects of the present disclosure are not restricted to the one set forth herein. The above and other aspects of the present disclosure will become more apparent to one of ordinary skill in the art to which the present disclosure pertains by referencing the detailed description of the present disclosure given below.

According to an aspect of the disclosure, a device for manufacturing a display panel includes: a support portion on which a display substrate is mounted, a mask member disposed on a front surface of the support portion and defining a plurality of first openings corresponding to a transmission area of a laser light, a support member configured to be disposed on the display substrate and defining a plurality of second openings formed in an area corresponding to a plurality of donor substrates disposed on the display substrate, respectively, a pressing portion including a pressing member for pressing the support member and the plurality of donor substrates disposed on the display substrate, and a laser irradiation portion disposed on an upper portion of the mask member for irradiating the laser light to light emitting elements of the donor substrates. The support member has a height equal to a sum of a thickness of each of the donor substrates and a height of each of the light emitting elements. Hence, the support member absorbs pressure otherwise acting onto the donor substrates due to its thickness and the common rest on the display substrate. The height of the support member may at least be equal to the sum of the thickness of each of the donor substrates and the height of each of the light emitting elements.

According to an embodiment, the second opening may overlap the first openings and the donor substrates in a plan view. An advantage of this embodiment may be that laser light can illuminate the donor substrates with low optical aberration, e.g. astigmatism.

According to an embodiment, the support member may protrude outwardly from the display substrate in the plan view. An advantage of this embodiment may be that laser light can illuminate the donor substrates with low shadowing. Alternatively or additionally, the surface of the support member that receives pressure can be larger than without the support member protruding, thereby improving stability.

According to an embodiment, the mask member may include a base layer, which transmits the laser light, and a light blocking pattern layer disposed on the base layer and defining the first openings. An advantage of this embodiment may be that laser light is prevented from heating elements of the pressing portion, which reduces thermal expansion of these elements and/or reduces the effort required for cooling.

According to an embodiment, the mask member may be a photomask, and further include a protective layer disposed on the light blocking pattern layer. An advantage of this embodiment may be that the light blocking pattern layer is at least partly protected from direct exposure, thereby reducing heating of the light blocking pattern layer by the laser light.

According to an embodiment, the pressing member may include a first light transmitting plate and a second light transmitting plate. The first light transmitting plate and a second light transmitting plate may be disposed on the support member. The first light transmitting plate and the second light transmitting plate may overlap each other in a thickness direction of the support portion. and between which A sealed space may be formed between the first light transmitting plate and the second light transmitting plate. The pressing member may further include a gas pressure regulator for controlling gas pressure in the sealed space and a gas conduit connected between the gas pressure regulator and the sealed space. An advantage of this embodiment may be that gas pressure in the sealed space can be regulated, thereby easily regulating the pressure caused by the pressing member.

According to an embodiment, the second light transmitting plate may move downward when a gas pressure in the sealed space increases. An advantage of this embodiment may be that pressure can be transferred easily.

According to an embodiment, the device and for example the pressing member may further include a holding frame, which fixes opposite ends of the first light transmitting plate and opposite ends of the second light transmitting plate. The device and for example the pressing member my comprise a buffer disposed between the second light transmitting plate and the holding frame. An advantage of this embodiment may be that that buffer can elastically guide the movement of the second light transmitting plate.

According to an embodiment, the base layer may be disposed closer to the display substrate than the protective layer is. An advantage of this embodiment may be that also the base layer is protected by the protective layer.

According to an embodiment, the base layer may be disposed closer to the laser irradiation portion than the protective layer is. An advantage of this embodiment may be that protective shadowing caused by the protective layer can be more precise potentially allowing for a smaller protective layer.

According to an embodiment, the device may further include a first mounting member. The first mounting member may be fixed to a bottom or top surface of an outer portion of the mask member. The first mounting member may support the mask member. The device may comprise a second mounting member. The second mounting member may be fixed to a bottom surface of an outer portion of the support member. The second mounting member may support the support member. An advantage of this embodiment may be that the support member can be handled easily.

According to an embodiment, the mask member may be disposed between the support member and the pressing member. An advantage of this embodiment may be that the mask member can be held by the pressing member, which avoids additional elements for holding the mask member.

According to an embodiment, the mask member may be disposed between the pressing member and the laser irradiating portion An advantage of this embodiment may be that the pressing member can directly interact with the support member without the mask member therebetween.

According to an embodiment, the mask member may be a metal mask having reflective properties and defining the first openings. An advantage of this embodiment may be that laser light irradiating the mask member is reflected, such that the mask member heats up less, and/or the heat can be dissipated effectively by the mask member.

According to an embodiment, the metal mask may include a first side and a second side facing the first side. The first side and the second side may define each of the first openings. A first angle formed by the first side and a top surface of the metal mask and a second angle formed by the top surface and the second side may be the same such that each of the first openings has an equilateral trapezoidal shape in a cross-sectional view, or the first side and the second side may have curvature. An advantage of this embodiment may be that shadowing caused by the metal mask is avoided.

According to an embodiment, the first light transmitting plate and the second light transmitting plate may be formed of a rigid material. An advantage of this embodiment may be that the first and second light transmitting plates can at least contribute to the rigidity of the pressing member.

According to an embodiment, the first light transmitting plate may be formed of a rigid material, and the second light transmitting plate may be formed of an elastic material. An advantage of this embodiment may be that the first light transmitting plates can at least contribute to the rigidity of the pressing member, while the second light transmitting plate avoids damages cause by undesired, but potentially unavoidable contacts with other elements of the device.

According to another aspect of the disclosure, a method of manufacturing a display panel includes: arranging a display substrate on a support portion; disposing a plurality of donor substrates and a support member on the display substrate, where the plurality of donor substrates are disposed in a plurality of second openings defined by the support member, respectively; disposing a mask member and a pressing member on the plurality of donor substrates; pressing the donor substrates by the pressing member; and irradiating laser light to light emitting elements of the donor substrates through a plurality of first openings defined by the mask member. The support member has a height equal to a sum of a thickness of each of the donor substrates and a height of each of the light emitting elements. Hence, the support member absorbs pressure otherwise acting onto the donor substrates due to its thickness. The height of the support member may at least be equal to the sum of the thickness of each of the donor substrates and the height of each of the light emitting elements.

According to an embodiment, the pressing member may include a first light transmitting plate and a second light transmitting plate. The first light transmitting plate and the second light transmitting plate may be disposed on the support member and overlap each other in a thickness direction of the support portion. A sealed space may be formed between the first light transmitting plate and the second light transmitting plate. The pressing member may control a gas pressure of the sealed space to move the second light transmitting plate downward to pressurize the donor substrates. An advantage of this embodiment may be that gas pressure in the sealed space can be regulated, thereby easily regulating the pressure caused by the pressing member.

According to an embodiment, the method may further include: disposing a laser irradiating portion on an upper portion of the mask member. The laser irradiating portion may irradiate the laser light to the light emitting elements of the donor substrates. Laser light may pass through the first openings of the mask member and may passe through the second openings of the support member and may irradiate the light emitting elements of the donor substrates. Laser light irradiated to an area other than the first openings of the mask member may be blocked. An advantage of this embodiment may be that only the light emitting elements are heated by the laser light, whereas components of the device are at least not directly heated by the laser light, reducing heat load and undesired thermal expansion and/or reducing cooling requirements of the device.

The display substrate may be removed from the device after the transfer of the light emitting elements onto the display substrate has taken place. Consecutively, another display substrate may be mounted to the device to be provided with further light emitting elements. The height of the support member may at least be equal to the sum of a predefined thickness of each of the donor substrates and a predefined height of each of the light emitting elements. For example, the height may be up to 1 %, up to 2 %, up to 3 %, up to 4 %, up to 5 %, up to 6 %, up to 7 %, up to 8 %, up to 9 %, up to 10 %, up to 12.5 % or up to 15 % larger than the sum of the predefined thickness of each of the donor substrates and the predefined height of each of the light emitting elements.

The display panel manufacturing device according to some embodiments may provide that a laser light irradiated to the peripheral area other than the micro LED is reflected by the reflective member of the light emitting plate, thereby protecting the display substrate from the laser light. Furthermore, a uniform pressurizing force may be provided on a plurality of donor substrates by using the support member. Accordingly, the occurrence of manufacturing defects of the target substrate or the display panel may be prevented, and manufacturing efficiency may be improved.

However, the effects of the present disclosure are not limited to the aforementioned effects, and various other effects are included in the present specification.

### BRIEF DESCRIPTION OF THE DRAWINGS

The above and other aspects and features of the present disclosure will become more apparent by describing in detail exemplary embodiments thereof with reference to the attached drawings, in which:
FIG. 1 is a plan view of a display device according to one embodiment.
FIG. 2 is a plan view schematically illustrating an emission area of each pixel according to one embodiment.
FIG. 3 is a plan view schematically illustrating the emission area of each pixel according to another embodiment.
FIG. 4 is a cross-sectional view schematically illustrating the line A - A' of FIG. 2 according to one embodiment.
FIG. 5 is an enlarged view schematically illustrating the first emission area of FIG. 4.
FIG. 6 is a cross-sectional view illustrating the light emitting element of FIG. 5 in detail.
FIG. 7 is a side cross-sectional view schematically illustrating a manufacturing device for a display panel according to one embodiment.
FIG. 8 is a front view schematically illustrating the top surface of the manufacturing device shown in FIG. 7.
FIG. 9 is a plan view illustrating the shape of the support member shown in FIGS. 7 and 8.
FIG. 10 is a flow chart to illustrate a micro LED transfer method using a manufacturing device according to one embodiment.
FIGS. 11 to 15 are schematic diagrams to illustrate a micro LED transfer method using a manufacturing device according to one embodiment.
FIG. 16 is a side cross-sectional view schematically illustrating a display panel manufacturing device according to another embodiment.
FIG. 17 is a side cross-sectional view schematically illustrating a micro LED transfer method using the display panel manufacturing device of FIG. 16.
FIG. 18 is a side cross-sectional view schematically illustrating a display panel manufacturing device according to still another embodiment.
FIG. 19 is a side cross-sectional view schematically illustrating a micro LED transfer method using the display panel manufacturing device of FIG. 18.
FIG. 20 is a cross-sectional view schematically illustrating a manufacturing device for a display panel according to yet another embodiment.
FIG. 21 is a cross-sectional view illustrating a micro LED transfer method using the manufacturing device for the display panel of FIG. 20.

### DETAILED DESCRIPTION

The embodiments will now be described more fully hereinafter with reference to the accompanying drawings. The embodiments may, however, be provided in different forms and should not be construed as limiting. The same reference numbers indicate the same components throughout the disclosure. In the accompanying figures, the thickness of layers and regions may be exaggerated for clarity.

Some of the parts which are not associated with the description may not be provided in order to describe embodiments of the disclosure.

It will also be understood that when a layer is referred to as being "on" another layer or substrate, it can be directly on the other layer or substrate, or intervening layers may also be present. In contrast, when an element is referred to as being "directly on" another element, there may be no intervening elements present.

Further, the phrase "in a plan view" means when an object portion is viewed from above, (in other words, the plan view is a view in a thickness direction (i.e., third direction DR3) of a display device 10 or a support portion 200 of a manufacturing device for a display panel) and the phrase "in a schematic cross-sectional view" means when a schematic cross-section taken by vertically cutting an object portion is viewed from the side. The terms "overlap" or "overlapped" mean that a first object may be above or below or to a side of a second object, and vice versa. Additionally, the term "overlap" may include layer, stack, face or facing, extending over, covering, or partly covering or any other suitable term as would be appreciated and understood by those of ordinary skill in the art. The expression "not overlap" may include meaning such as "apart from" or "set aside from" or "offset from" and any other suitable equivalents as would be appreciated and understood by those of ordinary skill in the art. The terms "face" and "facing" may mean that a first object may directly or indirectly oppose a second object. In a case in which a third object intervenes between a first and second object, the first and second objects may be understood as being indirectly opposed to one another, although still facing each other.

The spatially relative terms "below," "beneath," "lower," "above," "upper," or the like, may be used herein for ease of description to describe the relations between one element or component and another element or component as illustrated in the drawings. It will be understood that the spatially relative terms are intended to encompass different orientations of the device in use or operation, in addition to the orientation depicted in the drawings. For example, in the case where a device illustrated in the drawing is turned over, the device positioned "below" or "beneath" another device may be placed "above" another device. Accordingly, the illustrative term "below" may include both the lower and upper positions. The device may also be oriented in other directions and thus the spatially relative terms may be interpreted differently depending on the orientations.

When an element is referred to as being "connected" or "coupled" to another element, the element may be "directly connected" or "directly coupled" to another element, or "electrically connected" or "electrically coupled" to another element with one or more intervening elements interposed therebetween. It will be further understood that when the terms "comprises," "comprising," "has," "have," "having," "includes" and/or "including" are used, they may specify the presence of stated features, integers, steps, operations, elements and/or components, but do not preclude the presence or addition of other features, integers, steps, operations, elements, components, and/or any combination thereof.

It will be understood that, although the terms "first," "second," "third," or the like may be used herein to describe various elements, these elements should not be limited by these terms. These terms are used to distinguish one element from another element or for the convenience of description and explanation thereof. For example, when "a first element" is discussed in the description, it may be termed "a second element" or "a third element," and "a second element" and "a third element" may be termed in a similar manner without departing from the teachings herein.

The terms "about" or "approximately" as used herein is inclusive of the stated value and means within an acceptable range of deviation for the particular value as determined by one of ordinary skill in the art, considering the measurement in question and the error associated with measurement of the particular quantity (for example, the limitations of the measurement system). For example, "about" may mean within one or more standard deviations, or within ± 30%, 20%, 10%, 5% of the stated value.

In the specification and the claims, the term "and/or" is intended to include any combination of the terms "and" and "or" for the purpose of its meaning and interpretation. For example, "A and/or B" may be understood to mean "A, B, or A and B." The terms "and" and "or" may be used in the conjunctive or disjunctive sense and may be understood to be equivalent to "and/or." In the specification and the claims, the phrase "at least one of" is intended to include the meaning of "at least one selected from the group of" for the purpose of its meaning and interpretation. For example, "at least one of A and B" may be understood to mean "A, B, or A and B."

Unless otherwise defined or implied, all terms used herein (including technical and scientific terms) have the same meaning as commonly understood by those skilled in the art to which this disclosure pertains. It will be further understood that terms, such as those defined in commonly used dictionaries, should be interpreted as having a meaning that is consistent with their meaning in the context of the relevant art and will not be interpreted in an ideal or excessively formal sense unless clearly defined in the specification.

Hereinafter, exemplary embodiments of the present disclosure will be described in detail with reference to the accompanying drawings.

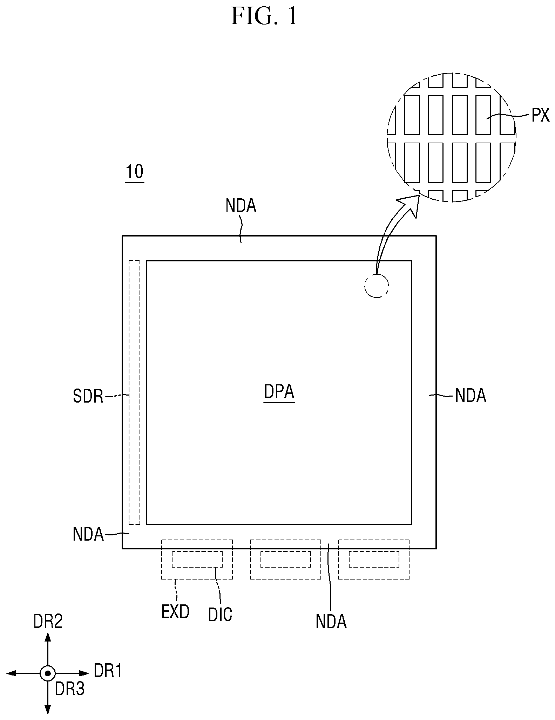

FIG. 1 is a plan view of a display device according to one embodiment.

Referring to FIG. 1, a display device 10 according to one embodiment may be applied to a smartphone, cell phone, tablet PC, personal digital assistant (PDA), portable multimedia player (PMP), television, gaming device, wristwatch-type electronic device, head-mounted display, monitor of a personal computer, laptop computer, car navigation, car instrument panel, digital camera, camcorder, exterior billboard, billboard, medical device, testing device, various consumer electronics such as refrigerators and washing machines, or Internet of Things device. In this specification, a television is described as an example of a display device, and the TV may have high or ultra-high resolution such as HD, UHD, 4K, 8K, and the like.

In addition, the display device 10 according to one embodiment may be classified into various ways depending on the display method. For example, the classification of display device may include an organic light-emitting display device (OLED), an inorganic light-emitting display device (inorganic EL), a quantum dot light-emitting display device (QED), a micro-LED display device (micro-LED), a nano-LED display device (nano-LED), a plasma display device (PDP), a field emission display device (FED), a cathode ray display device (CRT), a liquid crystal display device (LCD), an electrophoretic display device (EPD), and the like. In the following, a micro LED display device will be described as an example as a display device, and the micro-LED display device applied in the embodiments will be abbreviated as simply the display device unless otherwise indicated. However, the embodiment is not limited to the micro LED display device, and other display devices listed above or known in the art may be applied to the extent that they share the technical ideas.

Furthermore, in the following drawings, the first direction DR1 refers to the horizontal direction of the display device 10, the second direction DR2 refers to the vertical direction of the display device 10, and the third direction DR3 refers to the thickness direction of the display device 10. In this case, "left", "right", "up", and "down" refers to directions when the display device 10 is viewed from a plane. For example, "right" refers to one side of the first direction DR1, "left" refers to the other side of the first directionDR1, "top" refers to one side of the second direction DR2, and "bottom" refers to the other side of the second direction DR2. Furthermore, "top" or "front" refers to one side of the third direction DR3, and "bottom" or "back" refers to the other side of the third direction DR3.

The display device 10 according to one embodiment may have a circular, oval, or square shape in a plan view, for example, a square shape. Furthermore, when the display device 10 is a television, it may have a rectangular shape with the long side located in the horizontal direction. However, it is not limited to this, and the long side may be positioned in the vertical direction and may be installed to be rotatable so that the long side may be variably positioned in the horizontal or vertical direction.

The display device 10 may include a display area DPA and a non-display area NDA. The display area DPA may be an active area where an image is displayed. The display area DPA may have a square shape in a plan view similar to the overall shape of the display device 10 but is not limited to this and may have a circular or oval shape.

The display area DPA may include a plurality of pixels PX. The plurality of pixels PX may be arranged in a matrix direction. The shape of each pixel PX may be rectangular or square in a plan view but is not limited thereto and may be a rhombic shape with each side inclined with respect to the direction of one side of the display device 10. The plurality of pixels PX may include multiple color pixels PX. For example, the plurality of pixels PX may include, but are not limited to, a red first color pixel PX, a green second color pixel PX, and a blue third color pixel PX. Each color pixel PX may be alternately arranged in a stripe type or a pentile type.

A non-display area NDA may be disposed around the display area DPA. The non-display area NDA may completely or partially surround the display area DPA. The display area DPA may have various shapes, such as circular or square. The non-display area NDA may be formed to surround the display area DPA. The non-display area NDA may be composed of a bezel of the display device 10.

A driving circuit or driving element that drives the display area DPA may be disposed in the non-display area NDA. In one embodiment, a pad portion is provided on the display substrate of the display device 10 in the non-display area NDA disposed adjacent to the first side (lower side in FIG. 1) of the display device 10, and an external device EXD may be mounted on the electrode of the pad portion. Examples of the external device EXD include a connection film, a printed circuit board, a driving chip DIC, a connector, a wiring connection film, and the like. A scan driving portion SDR formed directly on the display substrate of the display device 10 may be disposed in the non-display area NDA adjacent to the second side (left side in FIG. 1) of the display device 10.

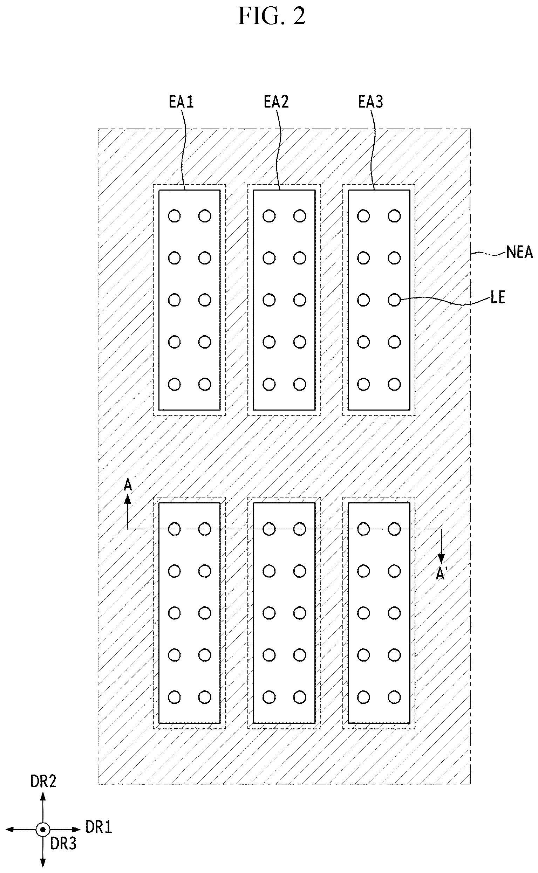

FIG. 2 is a plan view schematically illustrating the emission area of each pixel according to one embodiment.

Referring to FIG. 2, a plurality of pixels PX may be arranged in a matrix direction, and the plurality of pixels PX may be divided into a red first color pixel PX, a green second color pixel PX, and a blue third color pixel PX. Additionally, a white fourth color pixel PX may be further included.

The pixel electrode of the first color pixel PX is located in the first emission area EA1, but at least part of it may extend to the non-emission area NEA. The pixel electrode of the second color pixel PX is located in the second emission area EA2, but at least portion of it may extend to the non-emission area NEA. The pixel electrode of the third color pixel PX is located in the third emission area EA3, but at least portion of it may extend to the non-emission area NEA. The pixel electrode of each pixel PX may be connected to one or more switching elements included in the respective pixel circuit penetrating at least one layer of insulating layer.

A plurality of light emitting elements LE are disposed on the pixel electrode of the first emission area EA1, the pixel electrode of the second emission area EA2, and the pixel electrode of the third emission area EA3. Here, each light emitting element LE may be formed of a micro LED. The light emitting elements LE are disposed in each of the first emission area EA1, the second emission area EA2, and the third emission area EA3. Additionally, a red first color filter, a green second color filter, and a blue third color filter may be disposed on the first emission area EA1, the second emission area EA2, and the third emission area EA3, respectively, where the plurality of light emitting elements LE are disposed. A first organic layer FOL may be disposed in the non-emission area NEA.

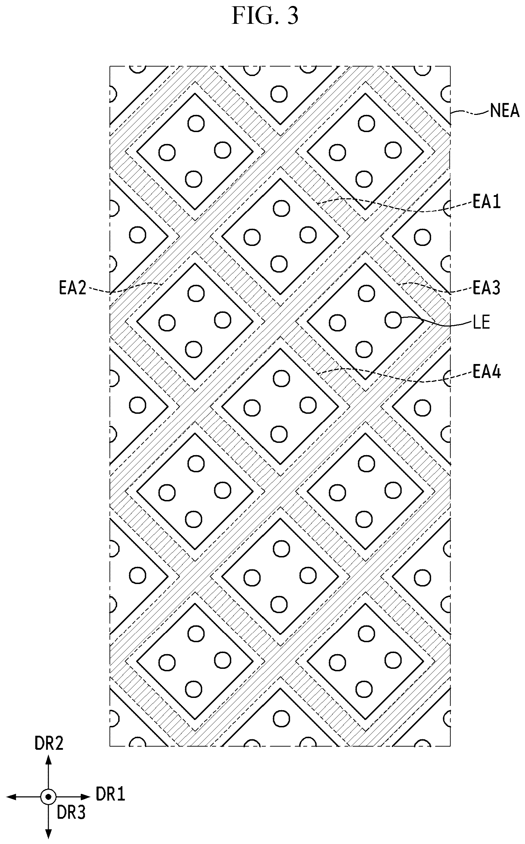

FIG. 3 is a plan view schematically illustrating the emission area of each pixel according to another embodiment.

Referring to FIG. 3, the shape of each pixel PX is not limited to a rectangular or square shape in a plan view but may be a rhombus shape in which each side is inclined with respect to one side of the display device 10 to form a pentile structure. Accordingly, each pixel PX of the pen tile structure may be formed in a rhombus shape with a first emission area EA1 of the first color pixel PX, a second emission area EA2 of the second color pixel PX, a third emission area EA3 of the third color pixel PX, and a fourth emission area EA4 of any of the first to third colors of the color pixel PX.

The size or planar area of the first to fourth emission areas EA1 to EA4 of each pixel PX may be the same or different from each other. Similarly, the number of light emitting elements LE formed in the first to fourth emission areas EA1 to EA4 may be the same or different from each other.

The area of the first emission area EA1, the area of the second emission area EA2, the area of the third emission area EA3, and the area of the fourth emission area EA4 may be substantially the same but may be different from each other, without limitation. The distance between adjacent first and second emission areas EA1 and EA2 that are adjacent to each other, the distance between the second and third emission areas EA2 and EA3 that are adjacent to each other, the distance between the adjacent first and third emission areas EA1 and EA3 that are adjacent to each other, and the distance between the adjacent third and fourth emission areas EA3 and EA4 that are adjacent to each other may be substantially the same or may be different from each other. The embodiments of this disclosure are not limited thereto.

In addition, the first emission area EA1 may emit the first light, the second emission area EA2 may emit the second light, and the third emission area EA3 and the fourth emission area EA4 may emit the third light but embodiments of the present disclosure are not limited thereto. For example, the first emission area EA1 may emit the second light, the second emission area EA2 may emit the first light, and the third and fourth emission areas EA3 and EA4 may emit the third light. Alternatively, the first emission area EA1 may emit the third light, the second emission area EA2 may emit the second light, and the first and fourth emission areas EA3 and EA4 may emit the first light. Alternatively, at least one of the first to fourth emission areas EA1 to EA4 may emit a fourth light. The fourth light may be light in a yellow wavelength band. That is, the main peak wavelength of the fourth light may be located at approximately 550 nanometers (nm) to 600 nm, but the embodiments of the present disclosure are not limited thereto.

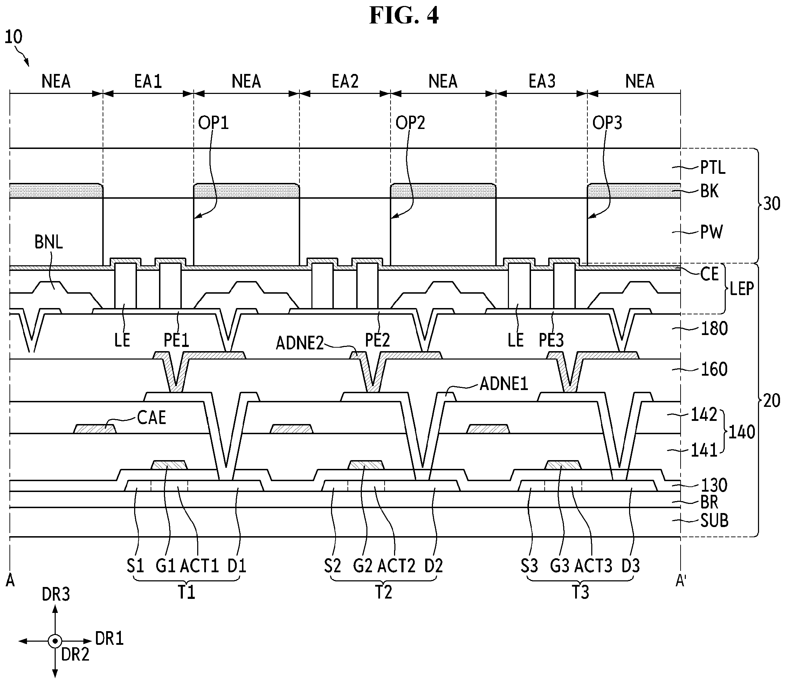

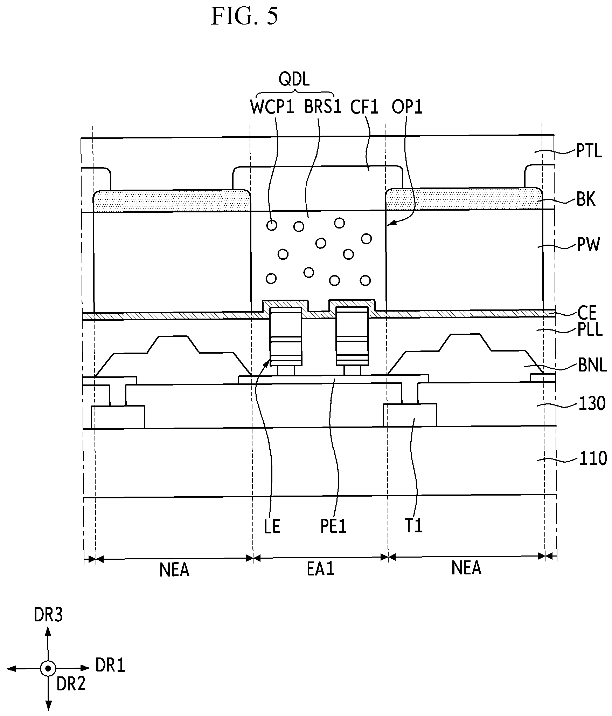

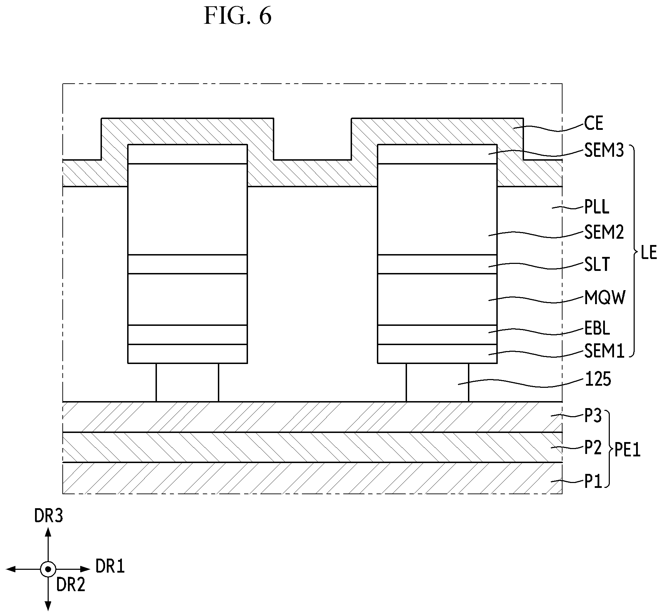

FIG. 4 is a cross-sectional view schematically illustrating the line A - A' of FIG. 2 according to one embodiment. FIG. 5 is an enlarged view schematically illustrating the first emission area of FIG. 4. FIG. 6 is a cross-sectional view illustrating the light emitting element of FIG. 5 in detail.

Referring to FIGS. 4 to 6, the display panel of the display device 10 may include a display substrate 20 and a wavelength conversion portion 30 disposed on the display substrate 20.

A barrier film BR may be disposed on the first substrate 110 of the display substrate 20. The first substrate 110 may be made of an insulating material such as polymer resin. For example, the first substrate 110 may be made of polyimide. The first substrate 110 may be a flexible substrate capable of bending, folding, rolling, and the like.

The barrier film BR is a film to protect the thin film transistors T1, T2, and T3 and the light emitting element LEP from moisture penetrating through the first substrate 110, which is vulnerable to moisture penetration. The barrier film BR may be composed of a plurality of inorganic films stacked alternately. For example, the barrier film BR may be formed as a multilayer of alternately stacked inorganic films of one or more of a silicon nitride layer, a silicon oxynitride layer, a silicon oxide layer, a titanium oxide layer, and an aluminum oxide layer.

Each transistor T1, T2, and T3 may be disposed on the barrier film BR. Each thin film transistor T1, T2, and T3 includes an active layer ACT1, a gate electrode G1, a source electrode S1, and a drain electrode D1.

The active layer ACT1, source electrode S1, and drain electrode D1 of the thin film transistors T1, T2, and T3 may be disposed on the barrier film BR. The active layer ACT1 of the thin film transistors T1, T2, and T3 may include polycrystalline silicon, monocrystalline silicon, low temperature polycrystalline silicon, amorphous silicon, or an oxide semiconductor. The active layer ACT1 overlapping the gate electrode G1 in the third direction DR3, which is the thickness direction of the first substrate 110, may be defined as a channel region. The source electrode S1 and the drain electrode D1 are regions that do not overlap with the gate electrode G1 in the third direction DR3 and may have conductivity due to doping of ions or impurities in the silicon semiconductor or oxide semiconductor.

A gate insulating layer 130 may be disposed on the active layer ACT1, the source electrode S1, and the drain electrode D1 of the thin film transistors T1, T2, and T3. The gate insulating layer 130 may be formed of an inorganic film, such as a silicon nitride layer, a silicon oxynitride layer, a silicon oxide layer, a titanium oxide layer, or an aluminum oxide layer.

A gate electrodes G1 of thin film transistors T1, T2, and T3 may be disposed on the gate insulating layer 130. The gate electrode G1 may overlap the active layer ACT1 in the third direction DR3. The gate electrode G1 may be formed of an inorganic film, such as a silicon nitride layer, a silicon oxynitride layer, a silicon oxide layer, a titanium oxide layer, or an aluminum oxide layer.

A first interlayer-insulating film 141 may be disposed on the gate electrode G1 of the thin film transistors T1, T2, and T3. The first interlayer-insulating film 141 may be formed of an inorganic film, such as a silicon nitride layer, a silicon oxynitride layer, a silicon oxide layer, a titanium oxide layer, or an aluminum oxide layer. The first interlayer-insulating film 141 may be formed of a plurality of inorganic films.

A capacitor electrode CAE may be disposed on the first interlayer-insulating film 141. The capacitor electrode CAE may overlap the gate electrode G1 of the thin film transistors T1, T2, and T3 in the third direction DR3. Since the first interlayer-insulating film 141 has a predetermined dielectric constant, a capacitor may be formed by the capacitor electrode CAE, the gate electrode G1, and the first interlayer-insulating film 141 disposed between them. The capacitor electrode CAE may be formed as a single layer or multiple layers of any one of molybdenum (Mo), aluminum (Al), chromium (Cr), gold (Au), titanium (Ti), nickel (Ni), neodymium (Nd), and copper (Cu), or an alloy thereof.

A second interlayer-insulating film 142 may be disposed on the capacitor electrode CAE. The second interlayer-insulating film 142 may be formed of an inorganic film, such as a silicon nitride layer, a silicon oxynitride layer, a silicon oxide layer, a titanium oxide layer, or an aluminum oxide layer. The second interlayer-insulating film 142 may be formed of a plurality of inorganic films.

A first anode connection electrode ANDE1 may be disposed on the second interlayer-insulating film 142. The first anode connection electrode ANDE1 may be connected to the drain electrode D1 of the thin film transistor ST1 through a first connection contact hole ANCT1 penetrating the gate insulating layer 130, the first interlayer-insulating film 141, and the second interlayer-insulating film 142. The first anode connection electrode ANDE1 may be formed as a single layer or multiple layers of any one of molybdenum (Mo), aluminum (Al), chromium (Cr), gold (Au), titanium (Ti), nickel (Ni), neodymium (Nd), and copper (Cu), or an alloy thereof.

A first planarization film 160 may be disposed on the first anode connection electrode ANDE1 to flatten the steps caused by the thin film transistors T1, T2, and T3. The first planarization film 160 may be formed of an organic film such as an acrylic resin, an epoxy resin, a phenolic resin, a polyamide resin, a polyimide resin, or the like.

A second anode connection electrode ANDE2 may be disposed on the first planarization film 160. The second anode connection electrode ANDE2 may be connected to the first anode connection electrode ANDE1 through a second connection contact hole ANCT2 penetrating the first planarization film 160. The second anode connection electrode ANDE2 may be formed as a single layer or multiple layers of any one of molybdenum (Mo), aluminum (Al), chromium (Cr), gold (Au), titanium (Ti), nickel (Ni), neodymium (Nd), and copper (Cu), or an alloy thereof.

A second planarization film 180 may be disposed on the second anode connection electrode ANDE2. The second planarization film 180 may be formed of an organic film such as an acrylic resin, an epoxy resin, a phenolic resin, a polyamide resin, a polyimide resin, or the like.

A light emitting element portion LEP may be formed on the second planarization film 180. The light emitting element portion LEP may include a plurality of pixel electrodes PE1, PE2, and PE3, a plurality of light emitting elements LE, and a common electrode CE.

The plurality of pixel electrodes PE1, PE2, and PE3 may include a first pixel electrode PE1, a second pixel electrode PE2, and a third pixel electrode PE3. The first pixel electrode PE1, the second pixel electrode PE2, and the third pixel electrode PE3 may serve as the first electrode of the light emitting element LE and may be an anode electrode or a cathode electrode. The first pixel electrode PE1 may be located in the first emission area EA1 but may extend at least partially into the non-emission area NEA. The second pixel electrode PE2 may be located in the second emission area EA2 but may extend at least partially into the non-emission area NEA. The third pixel electrode PE3 is located in the third emission area EA3 but may extend at least partially into the non-emission area NEA. The first pixel electrode PE1 may be connected to a first switching element T1 by penetrating the gate insulating layer 130, the second pixel electrode PE2 may be connected to a second switching element T2 by penetrating the gate insulating layer 130, and the third pixel electrode PE3 may be connected to the third switching element T3 by penetrating the gate insulating layer 130.

The first pixel electrode PE1, the second pixel electrode PE2, and the third pixel electrode PE3 may be reflective electrodes. The first pixel electrode PE1, the second pixel electrode PE2, and the third pixel electrode PE3 may be formed of titanium (Ti) or copper (Cu) or an alloy material of titanium (Ti) and copper (Cu). Also, it may have a laminated film structure of Ti (Titanium) and Copper (Cu). Further, the first pixel electrode PE1, the second pixel electrode PE2, and the third pixel electrode PE3 may be formed from a material layer having a high work function of titanium oxide (TiO₂), indium tin oxide (ITO), indium zinc oxide (IZO), zinc oxide (ZnO), indium tin zinc oxide (ITZO), or magnesium oxide (MgO) and silver (Ag), magnesium (Mg), aluminum (Al), platinum (Pt), lead (Pd), gold (Au), nickel (Ni), neodymium (Nd), iridium (Ir), chromium (Cr), lithium (Li), calcium (Ca), titanium (Ti), copper (Cu), or mixtures thereof, or the like. A material layer with a high work function may be disposed above the reflective material layer and may be disposed close to the light emitting element LE. The first pixel electrode PE1, the second pixel electrode PE2, and the third pixel electrode PE3 may have a multilayer structure of ITO/Mg, ITO/MgF, ITO/Ag, ITO/Ag/ITO, but are not limited thereto.

A bank BNL may be located on the first pixel electrode PE1, the second pixel electrode PE2, and the third pixel electrode PE3. The bank BNL may include an opening exposing the first pixel electrode PE1, an opening exposing the second pixel electrode PE2, and an opening exposing the third pixel electrode PE3, and may define an emission area EA1, a second emission EA2, a third emission EA3, and a non-emission area NEA. In other words, the area of the first pixel electrode PE1 that is not covered by the bank BNL and is exposed may be the first emission area EA1. The area of the second pixel electrode PE2 that is not covered by the bank BNL and is exposed may be the second emission area EA2. The area of the third pixel electrode PE3 that is not covered by the bank BNL and is exposed may be the third emission area EA3. In addition, the area where the bank BNL is located may be the non-emission area NEA.

The bank BNL may include an organic insulating material, for example, a polyacrylates resin, an epoxy resin, a phenolic resin, a polyamides resin, a polyimides rein, unsaturated polyesters resin, poly phenylenethers resin, polyphenylenesulfides resin, or benzocyclobutene (BCB).

In one embodiment, the bank BNL may overlap with the color filters CF1, CF2, and CF3 and the light blocking member BK of the wavelength conversion portion 30, which will be described later. In one embodiment, the bank BNL may completely overlap light blocking member BK. Additionally, the bank BNL may overlap the first color filter CF1, the second color filter CF2, and the third color filter CF3 in a plan view.

A plurality of light emitting elements LE may be disposed on the first pixel electrode PE1, the second pixel electrode PE2, and the third pixel electrode PE3.

As shown in FIGS. 5 and 6, the light emitting element LE may be disposed in each of the first emission area EA1, the second emission area EA2, and the third emission area EA3. The light emitting element LE may be a vertical light emitting diode element extending long in the third direction DR3. That is, the length of the light emitting element LE in the third direction DR3 may be longer than the length in the horizontal direction. The length in the horizontal direction refers to the length in the first direction DR1 or the length in the second direction DR2. For example, the length of the light emitting element LE in the third direction DR3 may be approximately 1 to 5 µm.

Each light emitting element LE may be a micro light emitting diode (micro LED). The light emitting element LE may be connected to a connection electrode 125, a first semiconductor layer SEM1, an electron blocking layer EBL, an active layer MQW, a superlattice layer SLT, a second semiconductor layer SEM2, and a third semiconductor layer SEM3 in the thickness direction of the display substrate 20, i.e., the third direction DR3. The connection electrode 125, the first semiconductor layer SEM1, the electron blocking layer EBL, the active layer MQW, the superlattice layer SLT, the second semiconductor layer SEM2, and the third semiconductor layer SEM3 may be stacked sequentially in the third direction DR3.

The light emitting element LE may have a cylindrical shape, a disk shape, a bridge shape, or a rod shape where the width is longer than the height. However, it is not limited to this, and the light emitting element LE may have a shape such as a rod, wire, tube, etc., a polygonal shape such as a cube, rectangular cube, hexagonal column, etc., or a shape that extends in one direction but has a partially sloped outer surface.

The connection electrode 125 may be disposed on top of each of the plurality of pixel electrodes PE1, PE2, and PE3. In the following, the light emitting element LE disposed on the first pixel electrode PE1 will be described as an example.

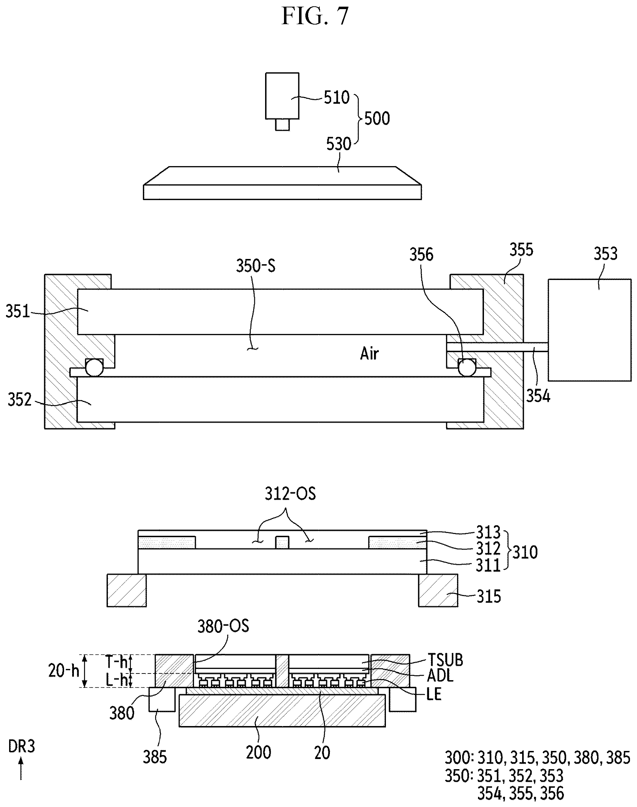

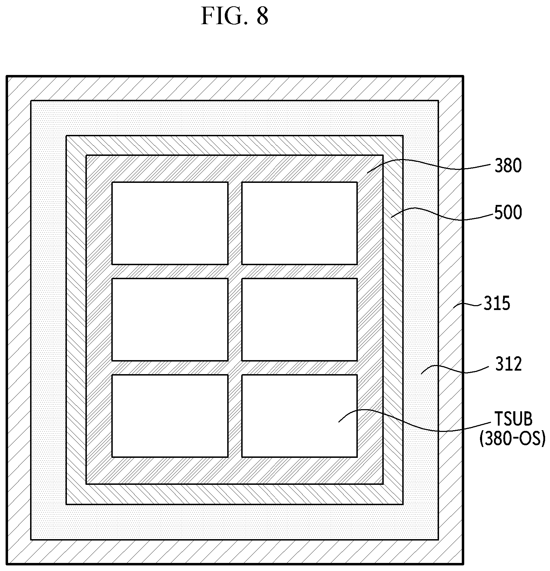

The connection electrode 125 may bond with the first pixel electrode PE1 and serve to apply an emission signal to the light emitting element LE. The connection electrode 125 may be an ohmic connection electrode. However, the electrode is not limited to this and may be a Schottky connection electrode. The light emitting element LE may include at least one connection electrode 125. FIG. 7 and 8 illustrate that the light emitting element LE includes one connection electrode 125, but the present disclosure is not limited thereto. In some cases, the light emitting element LE may include a greater number of connection electrodes 125 or may be omitted. The description of the light emitting element LE described later may be applied equally even if the number of connection electrodes 125 is different or a different structure is added.

The connection electrode 125 may reduce resistance and improve adhesion between the light emitting element LE and the first pixel electrode PE1 when the light emitting element LE is electrically connected to the first pixel electrode PE1 in the display device 10 according to one embodiment. The connection electrode 125 may include a conductive metal oxide. For example, the connection electrode 125 may be ITO. Since the connection electrode 125 is connected by direct contact with the lower first pixel electrode PE1, it may be made of the same material as the first pixel electrode PE1. Further, the connection electrode 125 may optionally further comprise a reflective electrode made of a highly reflective metal material such as aluminum (Al) or an antidiffusion layer comprising nickel (Ni). Accordingly, the adhesion between the connection electrode 125 and the first pixel electrode PE1 may be improved, thereby increasing the contact characteristics.

Referring to FIG. 6, in one embodiment, the first pixel electrode PE1 may include a lower electrode layer P1, a reflective layer P2, and an upper electrode layer P3. The lower electrode layer P1 may be disposed at the bottom of the first pixel electrode PE1 and may be electrically connected to the switching element. The lower electrode layer P1 may include a metal oxide, for example, titanium oxide (TiO₂), indium tin oxide (ITO), indium zinc oxide (IZO), zinc oxide (ZnO), indium tin zinc oxide (ITZO), or magnesium oxide (MgO).

The reflective layer P2 may be disposed on the lower electrode layer P1 to reflect light emitted from the light emitting element LE to the upper electrode layer. The reflective layer P2 may include a highly reflective metal, for example, silver (Ag), magnesium (Mg), aluminum (Al), platinum (Pt), lead (Pd), gold (Au), nickel (Ni), neodymium (Nd), iridium (Ir), chromium (Cr), lithium (Li), calcium (Ca), or a mixture thereof.

The upper electrode layer P3 is disposed on the reflective layer P2 and may be in direct contact with the light emitting element LE. The upper electrode layer P3 may be disposed between the reflective layer P2 and the connection electrode 125 of the light emitting element LE and may be in direct contact with the connection electrode 125. As described above, the connection electrode 125 is made of metal oxide, and the upper electrode layer P3 may also be made of metal oxide in the same way as the connection electrode 125.

The upper electrode layer P3 may be formed of titanium (Ti) or copper (Cu) or an alloy material of titanium (Ti) and copper (Cu). Also, it may have a laminated film structure of Ti (Titanium) and Copper (Cu). Further, the upper electrode layer P3 may include titanium oxide (TiO₂), indium tin oxide (ITO), indium zinc oxide (IZO), zinc oxide (ZnO), indium tin zinc oxide (ITZO), or magnesium oxide (MgO). In one embodiment, when the connection electrode 125 is made of ITO, the first pixel electrode PE1 may be made of a multilayer structure of ITO/Ag/ITO.

The first semiconductor layer SEM1 may be disposed on the connection electrode 125. The first semiconductor layer SEM1 may be a p-type semiconductor and may include a semiconductor material having a chemical formula of AlxGayln1-x-yN (0≤x≤1,0≤y≤1, 0≤x+y≤1). For example, it may be any one or more of p-type doped AlGalnN, GaN, AlGaN, InGaN, AIN, and InN. The first semiconductor layer SEM1 may be doped with a p-type dopant, and the p-type dopant may be Mg, Zn, Ca, Se, Ba, or the like. For example, the first semiconductor layer SEM1 may be p-GaN doped with p-type Mg. The thickness of the first semiconductor layer SEM1 may range from 30 nm to 200 nm but is not limited thereto.

The electron blocking layer EBL may be disposed on the first semiconductor layer SEM1. The electron blocking layer EBL may be a layer to suppress or prevent too many electrons from flowing into the active layer MQW. For example, the electron blocking layer EBL may be p-AlGaN doped with p-type Mg. The thickness of the electron blocking layer EBL may range from 10 nm to 50 nm but is not limited thereto. Additionally, the electron blocking layer EBL may be omitted.

The active layer MQW may be disposed on the electron blocking layer EBL. The active layer MQW may emit light by combining electron-hole pairs according to an electrical signal applied through the first semiconductor layer SEM1 and the second semiconductor layer SEM2.

The active layer MQW may include a single or multiple quantum well structure. If the active layer includes a material with a multi-quantum well structure, it may be a stacked structure with a plurality of well layers and a barrier layer alternating with each other. In this case, the well layer may be formed of InGaN and the barrier layer may be formed of GaN or AlGaN, but is not limited thereto. The thickness of the well layer may be approximately 1 to 4 nm, and the thickness of the barrier layer may be 3 nm to 10 nm.

Alternatively, the active layer MQW may have a structure in which a semiconductor material having a large band gap energy and a semiconductor material having a small band gap energy are alternately stacked with each other and may include other Group 3 to Group 5 semiconductor materials depending on the wavelength band of the emitted light. The light emitted from the active layer MQW is not limited to the first light and may emit second light (light of a green wavelength band) or third light (light of a red wavelength band) according to circumstances.

Specifically, the color of light emitted from the active layer MQW may vary depending on the indium (In) content. For example, as the content of indium (In) decreases, the wavelength band of light emitted by the active layer may shift to a red wavelength band, and as the content of indium (In) increases, the wavelength band of light emitted may shift to a blue wavelength band. In one example, if the indium (In) content is within 15%, the active layer MQW may emit first light in a red wavelength band with a main peak wavelength ranging from approximately 600 nm to 750 nm. In contrast, in one example, if the indium (In) content is set to 25%, the active layer MQW may emit second light in a green wavelength band with a main peak wavelength ranging from approximately 480 nm to 560 nm. Furthermore, when the indium (In) content is 35% or more, the active layer MQW may emit third light in a blue wavelength band with a main peak wavelength ranging from approximately 370 nm to 460 nm. Through FIG. 6, an example in which the active layer MQW emits light in a blue wavelength band with a main peak wavelength ranging from approximately 370 nm to 460 nm will be described.

The superlattice layer SLT may be disposed on the active layer MQW. The superlattice layer SLT may be a layer for relieving stress between the second semiconductor layer SEM2 and the active layer MQW. For example, the superlattice layer SLT may be formed of InGaN or GaN. The thickness of the superlattice layer SLT may be approximately 50 to 200 nm. The superlattice layer SLT may be omitted.

The second semiconductor layer SEM2 may be disposed on the superlattice layer SLT. The second semiconductor layer SEM2 may be an n-type semiconductor. The second semiconductor layer SEM2 may include a semiconductor material having the chemical formula AlxGayln1-x-yN (0≤x≤1,0≤y≤1, 0≤x+y≤1). For example, it may be one or more of n-type doped AlGalnN, GaN, AlGaN, InGaN, AIN, and InN. The second semiconductor layer SEM2 may be doped with an n-type dopant, and the n-type dopant may be Si, Ge, Sn, or the like. For example, the second semiconductor layer SEM2 may be n-GaN doped with n-type Si. The thickness of the second semiconductor layer SEM2 may range from 2 µm to 4 µm but is not limited thereto.

The third semiconductor layer SEM3 may be disposed on the second semiconductor layer SEM2. The third semiconductor layer SEM3 may be disposed between the second semiconductor layer SEM2 and the common electrode CE. The third semiconductor layer SEM3 may be an undoped semiconductor. The third semiconductor layer SEM3 may include the same material as the second semiconductor SEM2 but may be a material undoped with an n-type or p-type dopant. In one embodiment, the third semiconductor layer SEM3 may be at least one of undoped InAlGaN, GaN, AlGaN, InGaN, AIN, and InN but is not limited thereto.

A planarization layer PLL may be disposed on the bank BNL and the plurality of pixel electrodes PE1, PE2, and PE3. The planarization layer PLL may flatten a lower step so that a common electrode CE, which will be described later, may be formed. The planarization layer PLL may be formed at a predetermined height so that at least a portion of the plurality of light emitting elements LE, for example, an upper portion, may protrude above the planarization layer PLL. In other words, the height of the planarization layer PLL relative to the top surface of the first pixel electrode PE1 may be less than the height of the light emitting element LE.

The planarization layer PLL may include an organic material to flatten the lower step. For example, the planarization layer PLL may include a polyacrylates resin, an epoxy resin, a phenolic resin, a polyamides resin, a polyimides rein, an unsaturated polyesters resin, a polyphenylene resin, or a polyester resin, unsaturated polyesters resin, poly phenylenethers resin, polyphenylenesulfides resin, or benzocyclobutene (BCB).

A common electrode CE may be disposed on the planarization layer PLL and the plurality of light emitting elements LE. Specifically, the common electrode CE may be disposed on one surface of the first substrate 110 on which the light emitting element LE is formed and may be disposed throughout the display area DA and the non-display area NDA. The common electrode CE is disposed to overlap each of the emission areas EA1, EA2, and EA3 in the display area DA, and may be thin so that light may be emitted.

The common electrode CE may be directly disposed on the top and side surfaces of the plurality of light emitting elements LE. The common electrode CE may directly contact the second semiconductor layer SEM2 and the third semiconductor layer SEM3 on the side of the light emitting element LE. As shown in FIG. 6, the common electrode CE covers the plurality of light emitting elements LE and may be a common layer arranged to commonly connect the plurality of light emitting elements LE. Since the conductive second semiconductor layer SEM2 has a structure in which each light emitting element LE is patterned, the common electrode CE may directly contact a side of the second semiconductor layer SEM2 of each light emitting element LE such that a common voltage may be applied to each light emitting element LE.

Since the common electrode CE is disposed entirely on the first substrate 110 and applies a common voltage, it may include a material with low resistance. Further, the common electrode CE may be formed to be thin to facilitate light transmission. For example, the common electrode CE may include a material having a low resistance, such as aluminum (Al), silver (Ag), copper (Cu), or the like. The thickness of the common electrode CE may be approximately 10Å to 200Å but is not limited thereto.

The above-described light emitting elements LE may receive a pixel voltage or anode voltage from the pixel electrode through the connection electrode 125 and may receive a common voltage through the common electrode CE. The light emitting element LE may emit light with a predetermined brightness depending on the voltage difference between the pixel voltage and the common voltage.

In this embodiment, by disposing a plurality of light emitting elements LE, that is, inorganic light emitting diodes, on the pixel electrodes PE1, PE2, and PE3, the disadvantages of organic light emitting diodes, which are vulnerable to external moisture or oxygen, may be eliminated and the lifespan and reliability may be improved.

The wavelength conversion portion 30 may be disposed on the light emitting element portion LEP. The wavelength conversion portion 30 may include a partition wall PW, a wavelength conversion layer, color filters, a light blocking member BK, and a protective layer PTL.

The partition wall PW is disposed on the common electrode CE of the display area DPA and, together with the bank BNL, may compartmentalize a plurality of emission areas EA1, EA2, and EA2. The partition wall PW is arranged to extend in the first direction DR1 and the second direction DR2 and may be formed in a grid-like pattern throughout the display area DA. Furthermore, the partition wall PW may not overlap with the plurality of emission areas EA1, EA2, and EA3 and may overlap with the non-emission area NEA.

The partition wall PW may include a plurality of openings OP1, OP2, and OP3 exposing the lower common electrode CE. The plurality of openings OP1, OP2, and OP3 may include a first opening OP1 overlapping the first emission area EA1, a second opening OP2 overlapping the second emission area EA2, and a third opening OP3 overlapping the third emission area EA3. Here, the plurality of openings OP1, OP2, and OP3 may correspond to the plurality of emission areas EA1, EA2, and EA3. That is, the first opening OP1 corresponds to the first emission area EA1, the second opening OP2 corresponds to the second emission area EA2, and the third opening OP3 corresponds to the third emission area EA3.

The partition wall PW may serve to provide a space for forming the first and second wavelength conversion layers. To this end, the partition wall PW may be made of a predetermined thickness. For example, the thickness of the partition wall PW may be in the range of 1 µm to 10 µm. The partition wall PW may include an organic insulating material to have a predetermined thickness. The organic insulating material may include, for example, an epoxy-based resin, an acrylic-based resin, a cardo-based resin, or an imide-based resin.

The first wavelength conversion layer may be disposed within each of the first openings OP1. The first wavelength conversion layer may be formed in a dot-shaped island pattern spaced apart from each other. The first wavelength conversion layer may include a first base resin and a first wavelength conversion particles. The first base resin may include a light-transmitting organic material. For example, the first base resin may include an epoxy-based resin, an acrylic-based resin, a cardo-based resin, or an imide-based resin. The first wavelength conversion particle may be a quantum dot (QD), a quantum rod, a fluorescent material, or a phosphorescent material. For example, quantum dots may be particulate materials that emit a specific color as electrons transition from the conduction band to the valence band.

The quantum dot may be a semiconductor nanocrystal material. The quantum dots have a specific bandgap depending on their composition and size and may absorb light and then emit light with a unique wavelength. Examples of the semiconductor nanocrystals of the quantum dots include group IV nanocrystals, group II-VI compound nanocrystals, group III-V compound nanocrystals, group IV-VI nanocrystals, or combinations thereof.

The first wavelength conversion layer may be formed in the first opening OP1 of the first emission area EA1. The first wavelength conversion layer may convert or shift the peak wavelength of incident light into light of another specific peak wavelength and emit it. The first wavelength conversion layer may convert a portion of the blue light emitted from the light emitting element LE into light similar to red, which is the first light. The first wavelength conversion layer emits light similar to red so that may be converted into red light, which is the first light, through the first color filter.

The second wavelength conversion layer may be disposed within each of the second openings OP2. The second wavelength conversion layer may be formed in a dot-shaped island pattern spaced apart from each other. For example, the second wavelength conversion layer may be disposed to overlap the second emission area EA2. The second wavelength conversion layer may include a second base resin and second wavelength conversion particles. The second base resin may include a light-transmitting organic material. Accordingly, the second wavelength conversion layer may convert or shift the peak wavelength of the incident light into light of another specific peak wavelength and emit it. The second wavelength conversion layer may convert a portion of the blue light emitted from the light emitting element LE into light similar to green light, which is the second light. The second wavelength conversion layer emits light similar to green and may be converted into red light, which is the first light, through the second color filter.

In the third emission area EA3, only a transparent, light-transmitting organic material is formed in the third opening OP3, so that the blue light emitted from the light emitting element LE may be emitted as it is through the third color filter.

A plurality of color filters may be disposed on the partition wall PW and the first and second wavelength conversion layers. The plurality of color filters may be arranged to overlap the plurality of openings OP1, OP2, and OP3 and the first and second wavelength conversion layers in a plan view. The plurality of color filters may include a first color filter, a second color filter, and a third color filter.

The first color filter may be disposed to overlap the first emission area EA1. Further, the first color filter may be disposed on the first opening OP1 of the partition wall PW, overlapping with the first opening OP1 in a plan view. The first color filter may transmit the first light emitted from the light emitting element LE and absorb or block the second light and the third light. For example, the first color filter may transmit light in a blue wavelength band and absorb or block light in other wavelength bands such as green and red.

The second color filter may be disposed to overlap the second emission area EA2. Further, the second color filter may be disposed on the second opening OP2 of the partition wall PW, overlapping with the second opening OP2 in a plan view. The second color filter may transmit the second light and absorb or block the first light and the third light. For example, the second color filter may transmit light in a green wavelength band and absorb or block light in other wavelength bands such as blue and red.

The third color filter may be disposed to overlap the third emission area EA3. Further, the third color filter may be disposed on the third opening OP3 of the partition wall PW, overlapping with the third opening OP3 in a plan view. The third color filter may transmit third light and absorb or block first light and second light. For example, the third color filter may transmit light in a red wavelength band and absorb or block light in other wavelength bands such as blue and green.

The planar area of each of the plurality of color filters may be larger than the planar area of each of the plurality of emission areas EA1, EA2, and EA3. For example, the first color filter may be larger than the planar area of the first emission area EA1. The second color filter may be larger than the planar area of the second emission area EA2. The third color filter may be larger than the planar area of the third emission area EA3. However, the present disclosure is not limited to this, and the planar area of each of the plurality of color filters may be equal to the planar area of each of the plurality of emission areas EA1, EA2, and EA3.

Referring to FIG. 5, a light blocking member BK may be disposed on the partition wall PW. The light blocking member BK may block the transmission of light by overlapping the non-emission area NEA. The light blocking member BK may be arranged in a substantially grid-like arrangement on a plane, similar to the bank BNL or partition wall PW. The light blocking member BK may be disposed to overlap with the bank BNL and the partition wall PW and may not overlap with the emission areas EA1, EA2, and EA3.

In one embodiment, the light blocking member BK may include an organic light blocking material and may be formed through a coating and exposure process of the organic light blocking material. The light blocking member BK may include a dye or pigment having light blocking properties and may be a black matrix. At least a portion of the light blocking member BK may overlap with adjacent color filters in a plan view, and the color filters may be disposed on at least a portion of the light blocking member BK.

A protective layer PTL may be disposed on the plurality of color filters and the light blocking member BK. The first protective layer PTL may be disposed at the top of the display device 10 and may protect the plurality of color filters CF1, CF2, and CF3 and the light blocking member BK below. One surface, for example, a bottom surface, of the protective layer PTL may contact the plurality of color filters CF1, CF2, and CF3 and the upper surface of the light blocking member BK, respectively.

The protective layer PTL may include an inorganic insulating material to protect the plurality of color filters CF1, CF2, and CF3 and the light blocking member BK. For example, the first protective layer PTL may include silicon oxide (SiOx), silicon nitride (SiNx), silicon oxynitride (SiOxNy), aluminum oxide (AlxOy), aluminum nitride (AIN), and the like but is not limited to. The first protective layer PTF1 may have a predetermined thickness, for example, in the range of 0.01 to 1 µm. However, it is not limited to this.

Hereinafter, a manufacturing device for a display panel that pressurizes and attaches a plurality of light emitting elements LE, namely micro LED, disposed on the pixel electrodes PE1, PE2, and PE3 of the display substrate 20 will be described in detail.

FIG. 7 is a side cross-sectional view schematically illustrating a manufacturing device for a display panel according to one embodiment. FIG. 8 is a front view schematically illustrating the top surface of the manufacturing device shown in FIG. 7.

Referring to FIGS. 7 and 8, the manufacturing device for the display panel may bond two or more bonding objects to each other using a laser light. The bonding objects may be a substrate, a film, a display panel, a touch panel, or a semiconductor element such as a printed circuit board, a flexible circuit board, or a light emitting element. Hereinafter, an example in which a first bonding object is the display substrate 20 and a second bonding object is the light emitting element LE will be described. The display substrate 20 is a substrate onto which the light emitting elements LE are transferred and may be referred to as a "target substrate". Further, a plurality of light emitting elements LE may be disposed on a donor substrate TSUB and may be transferred to the target substrate. The donor substrate TSUB may be made of a transparent material to allow light to pass through. For example, the donor substrate TSUB may include a transparent polymer such as polyimide, polyester, polyacrylic, polyepoxy, polyethylene, polystyrene, polyethylene terephthalate, or the like. An adhesive layer ADL disposed on one surface of the donor substrate TSUB may include an adhesive material for bonding the plurality of light emitting elements LE. For example, the adhesive material may include urethane acrylate, epoxy acrylate, polyester acrylate, and the like. The donor substrate TSUB may be smaller than the target substrate 20. A plurality of donor substrates TSUB may be disposed on the target substrate 20.

The device for manufacturing a display panel may include a support portion 200, a pressing portion 300, and a laser irradiation portion 500.

The support portion 200 may have a top surface parallel to a plane defined by a first direction DR1 and a second direction DR2 perpendicular to each other A display substrate 20 having a plurality of light emitting elements LE arranged on the top surface may be mountable. The display substrate 20 may be removed from the device after the transfer of the light emitting elements LE onto the display substrate 20 has taken place. Consecutively, another display substrate 20 may be mounted to be provided with further light emitting elements LE.

The support portion 200 may be a loading plate and may be formed in a polygonal flat plate shape such as a square or rectangular shape. Additionally, the support portion 200 may be formed in a circular, oval, or other planar plate shape. Hereinafter, an example in which the support portion 200 is formed in the shape of a square flat plate shape will be described. In one embodiment, the support portion 200 may fix the display substrate 20.

The laser irradiation portion 500 may be disposed on the front side of the support portion 200 described later and irradiates laser light to the display substrate 20 through the support portion 200. The laser irradiation portion 500 may be disposed on the uppermost surface of the manufacturing device. The laser irradiation portion 500 irradiates laser light toward the support portion 200 on the lower surface, and the light irradiated from the laser irradiation portion 500 is applied to the plurality of light emitting elements LE disposed on the display substrate 20.

The laser irradiation portion 500 may include a laser light source 510 and an optical system 530.

The laser light source 510 may be a device capable of generating laser light by externally supplied energy and may be configured to generate laser light, such as, for example, a solid-state laser, such as a YAG laser, ruby laser, glass laser, YVO4 laser, LD laser, fiber laser, liquid laser, such as a pigment laser, CO₂ laser, excimer laser (ArF laser, KrF laser, XeCl laser, XeF laser, etc.), gaseous laser, such as an Ar laser, He-Ne laser, semiconductor laser, free-electron laser, etc.

The optical system 530 may include a plurality of lenses. The optical system 530 may receive beam-shaped laser light from the laser light source 510 and perform optical dispersion to enable area heating for a predetermined area.

The laser light emitted from the optical system 530 may irradiated to the light emitting elements LE arranged on the display substrate 20 mounted on the support portion 200 and may heat a predetermined area of the light emitting elements LE.

The pressing portion 300 may be spaced apart from the support portion 200 in the third direction DR3 and may be disposed on the front of the support portion 200. The pressing portion 300 may press the display substrate 20 and the light emitting element LE on the support portion 200.

The pressing portion 300 may include a mask member 310, a first mounting member 315, a pressing member 350, a support member 380, and a second mounting member 385.

The mask member 310 may be formed of a plurality of layers. The mask member 310 may include a base layer 311 and a light blocking pattern layer 312. In addition, the mask member 310 may further include a protective layer 313 on the light blocking pattern layer 312, but the protective layer 313 may be omitted. In another variation, the mask member 310 may have a base layer 311, a light blocking pattern layer 312, and the protective layer 313 sequentially disposed, with the base layer 311 being disposed on top and the protective layer 313 being disposed on the bottom.

The base layer 311 may be formed of a transparent or translucent flat plate including at least one transparent material such as glass, quartz, or silicon, etc. The base layer 311 allows laser light to be transmitted in the opposite direction, that is, the front or back.

The light blocking pattern layer 312 may be disposed on one surface of the base layer 311 and includes a pattern having light blocking or reflective properties. The thickness of the light blocking pattern layer 312 may not be particularly limited but may have a film thickness within the range of 80 nm to 180 nm and for example of at least 80 nm, 90 nm, 100 nm, 110 nm, 120 nm, 130 nm, 140 nm, 150 nm, 160 nm, 170 nm or up to 180 nm. If it is too thin, it may become difficult to obtain the desired light blocking or reflective properties, and if it is too thick, it may become difficult to process the light blocking pattern with high precision.

The light blocking pattern layer 312 may not be particularly limited as long as it is a material having light blocking properties, but may include, for example, chromium (Cr), chromium oxynitride (CrON), chromium nitride (CrN), molybdenum silicide oxide (MoSiO), molybdenum silicide oxynitride (MoSiON), tantalum oxide (TaO), tantalum silicide oxide (TaSiO), and the like. In one embodiment, chromium (Cr) is selected for the light blocking pattern layer 312.

The light blocking pattern layer 312 may define openings 312-OS therein. The light blocking pattern layer 312 may be included in the mask member 310, and since the openings 312-OS of the light blocking pattern layer 312 do not overlap with other components of the mask member 310 in a plan view, they may also be referred to as openings 312-OS of the mask member 310.

The laser light may be transmitted through the openings 312-OS. Accordingly, the opening 312-OS may define the penetration area of the laser light. Here, the laser light irradiated from the laser irradiation portion 500 is transmitted through the openings 312-OS and applied to a plurality of target substrates TSUB.

The opening of the light blocking pattern layer 312 may overlap with a target substrate TSUB in a plan view.

The light blocking pattern layer 312 may be disposed to face the light emitting element LE.

The protective layer 313 may be disposed on the base layer 311 on which the light blocking pattern layer 312 is provided, to protect the surface of the light blocking pattern layer 312 and prevent damage to the light blocking pattern. The thickness of the protective layer 313 may not be particularly limited but may have a film thickness within a range of about 2 to 3 µm. The protective layer 313 may be a transparent or translucent material including a transparent material, for example, a transparent resin.

The first mounting member 315 may be bonded to the outer back surface of the mask member 310. For example, the first mounting member 315 may be bonded to a peripheral back surface of the base layer 311. The first mounting member 315 may include, for example, one of an electrostatic chuck, an adhesive chuck, a vacuum chuck, and a porous vacuum chuck but is not limited thereto. For example, the first mounting member 315 may include a clamp. The first mounting member 315 does not overlap with the path of the laser light in a plan view.

The pressing member 350 may include a first light transmitting plate 351, a second light transmitting plate 352, a gas pressure regulator 353, a gas conduit 354, a holding frame 355, and a buffer 356.

The first light transmitting plate 351 and the second light transmitting plate 352 may be mounted on the holding frame 355 to overlap each other in the thickness direction (i.e., DR3). Accordingly, when the holding frame 355 is moved downward, the first light transmitting plate 351 and the second light transmitting plate 352 mounted on the holding frame 355 may also be moved downward to press and apply pressure to the mask member 310 located underneath.

A sealed space 350-S may be formed between the first light transmitting plate 351 and the second light transmitting plate 352.

The first light transmitting plate 351 may be formed as a rectangular plane having a long side in the first direction and a short side in the second direction intersecting the first direction. The corner where the long side in the first direction and the short side in the second direction meet may be formed at a right angle. The planar shape of the first light transmitting plate 351 and the second light transmitting plate 352 is not limited to a square, and may be formed into other polygonal, circular, or elliptical shape.

The first light transmitting plate 351 and the second light transmitting plate 352 may be formed of a light-transmitting material and may pass through the laser light emitted from the laser irradiation portion 500.

The first light transmitting plate 351 and the second light transmitting plate 352 may be made of any material that may withstand the pressure inside the sealed space 350-S. The first light transmitting plate 351 and the second light transmitting plate 352 may be made of a material such as tempered glass, quartz, acrylic, a metal oxide, or an oxide of a semi-metal, for example, silicon oxide, aluminum oxide, and the like. However, the present disclosure is not limited thereto. For example, the first light transmitting plate 351 and the second light transmitting plate 352 may be formed of silicon multi-layers, silicon-polyethylene terephthalate (PET) laminated layers, polydimethylsiloxane (PDMS), and the like.

The second light transmitting plate 352 generates a pressurizing force in the downward direction, i.e., in the direction of the mask member 310, by the pressure inside the sealed space 350-S.

The gas pressure regulator 353 may generate a pressurizing force by supplying gas to the sealed space 350-S between the first light transmitting plate 351 and the second light transmitting plate 352.

The gas pressure regulator 353 may supply an inert or extremely low chemical reactivity gas that may transmit a laser light, such as nitrogen (N), helium (He), neon (Ne), argon (Ar), carbon dioxide (CO₂), or a mixture thereof, to the sealed space 350-S. Hereinafter, gases that are inert or have extremely low chemical reactivity are collectively referred to as neutral gas.

The gas pressure regulator 353 may include a storage for storing gas, a gas pump for pressurizing and supplying the gas, and a gas valve for controlling the flow of the gas. The gas pump may be configured to supply gas into the sealed space 350-S at a pressure that is higher than the external pressure of the sealed space 350-S.

The gas valve may close the sealed space 350-S so that the supply of gas is stopped and the internal pressure of the sealed space 350-S is maintained when the pressure inside the sealed space 350-S is sufficiently high. The gas valve may be, for example, a ball valve, a globe valve, a gate valve, a control valve, or the like, and is not particularly limited.

The gas conduit 354 connects the gas pressure regulator 353 and the sealed space 350-S and provides a path for the gas to move. The gas may be moved between the gas pressure regulator 353 and the sealed space 350-S by the gas conduit 354.

In one embodiment, the gas conduit 354 may be formed by penetrating the holding frame 355 but is not limited thereto. For example, the gas conduit 354 may also be formed by penetrating the second light transmitting plate 352.

The holding frame 355 may fix both ends of the first light transmitting plate 351 and the second light transmitting plate 352.

The buffer 356 may be disposed between the second light transmitting plate 352 and the holding frame 355 to prevent impact between the second light transmitting plate 352 and the holding frame 355 when the second light transmitting plate 352 moves up and down depending on the filling state of the gas.

The buffer 356 may include an O-ring. The buffer 356 may be a polymer, rubber, Teflon, or any other resilient material.

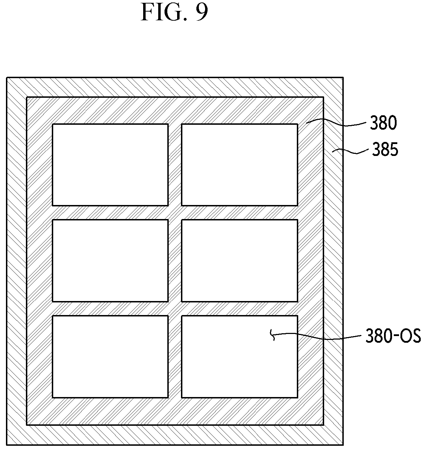

The support member 380 may be placed on the display substrate 20. For example, the support member 380 may be disposed between the display substrate 20 and the mask member 310. The support member 380 may have a plurality of openings (380-OS in FIG. 9), and a donor substrate TSUB may be disposed in each opening 380-OS. The plurality of openings 380-OS of the support member 380 may overlap with the openings 312-OS of the mask member 310 and may overlap with the plurality of donor substrates TSUB in a plan view.

The support member 380 may protrude further outward than the display substrate 20 in a plan view. In this way, the entire display substrate 20 may be evenly pressurized.

The support member 380 may have a height 20-h that is at least equal to the sum of the thickness T-h of the donor substrate TSUB disposed on the display substrate 20 and the height L-h of the light emitting element LE.

The support member 380 may be made of a material such as tempered glass, quartz, acrylic, a metal oxide or a metalloid oxide, for example, silicon oxide, aluminum oxide, etc. However, it is not limited thereto. For example, the support member 380 may be formed of silicone multi-layers, silicone-polyethylene terephthalate (PET) laminated layers, polydimethylsiloxane (PDMS), and the like. Furthermore, when formed of a material capable of reflecting laser light, it may have a function of protecting the display substrate 20 disposed on the bottom.

The second mounting member 385 may be bonded to one surface of the outer peripheral surface of the support member 380. For example, the second mounting member 385 may be attached to the rear surface of the outer surface of the support member 380. The second mounting member 385 may include, but is not limited to, any one of an electrostatic chuck, an adhesive chuck, a vacuum chuck, or a porous vacuum chuck. For example, the second mounting member 385 may be a clamp of the first mounting member 315. The second mounting member 385 does not overlap with the path of the laser light in a plan view.

FIG. 9 is a plan view illustrating the shape of the support member shown in FIGS. 7 and 8.

Referring to FIGS. 7 to 9, the support member 380 includes openings 380-OS. The target substrate TSUB may be disposed between the openings 380-OS.

The support member 380 may be disposed to overlap the display substrate 20 in an area other than the area where the target substrate TSUB is disposed. Therefore, when the pressing member 350 presses the target substrate TSUB, the support member 380 may support the mask member 310 to prevent deformation of the shape of the mask member 310.

Meanwhile, FIG. 9 illustrates six target substrates TSUB being disposed, but this is only an example and does not limit the number or arrangement of the target substrates TSUB.

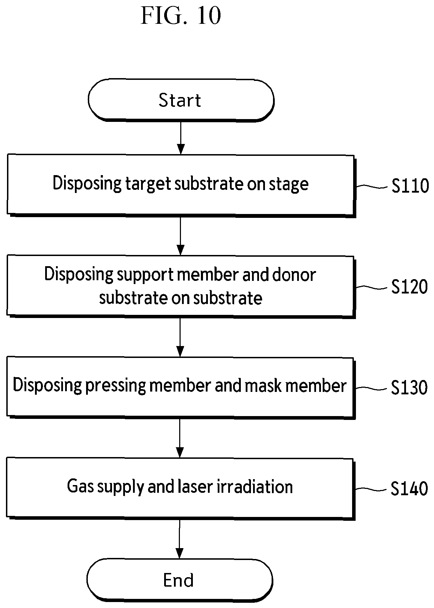

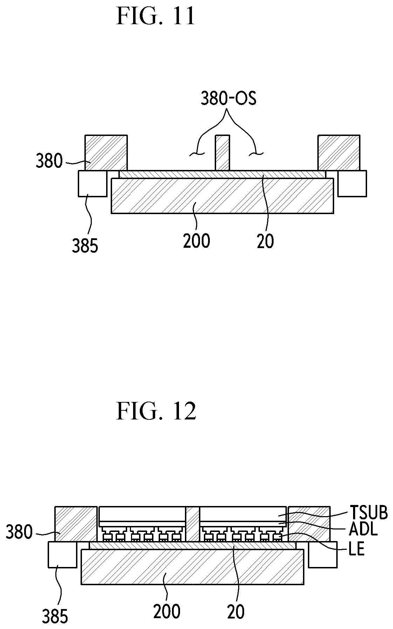

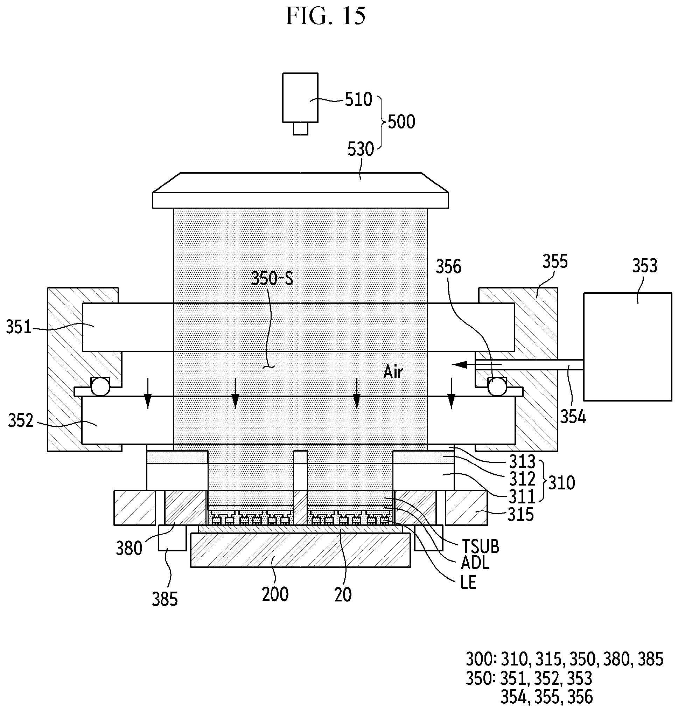

FIG. 10 is a flow chart to illustrate a micro LED transfer method using a manufacturing device according to one embodiment. FIGS. 11 to 15 are schematic diagrams to illustrate a micro LED transfer method using a manufacturing device according to one embodiment.

Hereinafter, a micro LED transfer method will be described with reference to FIG. 10 and FIG. 11 to FIG. 15. The manufacturing device for the display panel described with reference to FIG. 10 to FIG. 15 may be the manufacturing device for the display panel described with reference to FIG. 5 to FIG. 9.

First, a display substrate 20 may be placed on a support portion 200. (S110 in FIG. 11)

Second, a support member 380 and a plurality of donor substrates TSUB may be placed on the support portion 200. (S120 in FIG. 11)

For example, referring to FIG. 11, the support member 380 may be disposed on the front side of the display substrate 20. The support member 380 may be moved in a direction closer to the display substrate 20 (i.e., downward direction), thereby placing the support member 380 on the display substrate 20. As described with reference to FIG. 9, the support member 380 may have a plurality of openings 380-OS.

Referring to FIG. 12, a donor substrate TSUB may be disposed in the opening 380-OS of the support member 380. For example, a first donor substrate TSUB may be disposed in the first opening 380-OS, and a second donor substrate TSUB may be disposed in the second opening 380-OS.

The width of the opening 380-OS of the support member 380 may be the same to or wider than the width of the donor substrate TSUB.

Since the height of the support member 380 may be at least equal to the sum of the thickness of the donor substrate TSUB and the height of the light emitting element LE, it may be disposed on a straight line between the upper surface of the support member 380 and the donor substrate TSUB.

Meanwhile, in another embodiment, the light emitting element LE may be transferred onto the display substrate 20, and then the support member 380 may be disposed on the display substrate 20 so that the support member 380 does not overlap the light emitting element LE in a plan view. Even in this case, since the height of the support member 380 is at least equal to the sum of the thickness of the donor substrate TSUB and the height of the light emitting element LE, it may be disposed on a straight line between the support member 380 and the upper surface of the donor substrate TSUB. Any conventionally known method may be adopted as to the transfer method of the light emitting element LE.

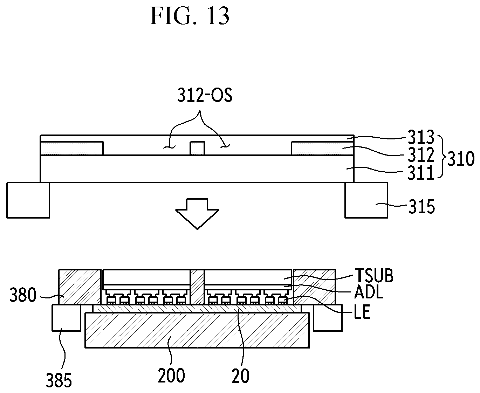

Third, the mask member 310 and the pressing member 350 may be disposed. (S130 in FIG. 11)
Referring to FIG. 13, the mask member 310 is first placed on the display substrate 20. The openings 312-OS defined by the light blocking pattern layer 312 of the mask member 310 and the openings 380-OS of the support member 380 may be aligned. The openings 310-OS of the mask member 310 may overlap with the donor substrate TSUB in a plan view. Since the mask member 310 may be light weight and has good mobility compared to the pressing member 350, the alignment is easy, and the precision may be improved.

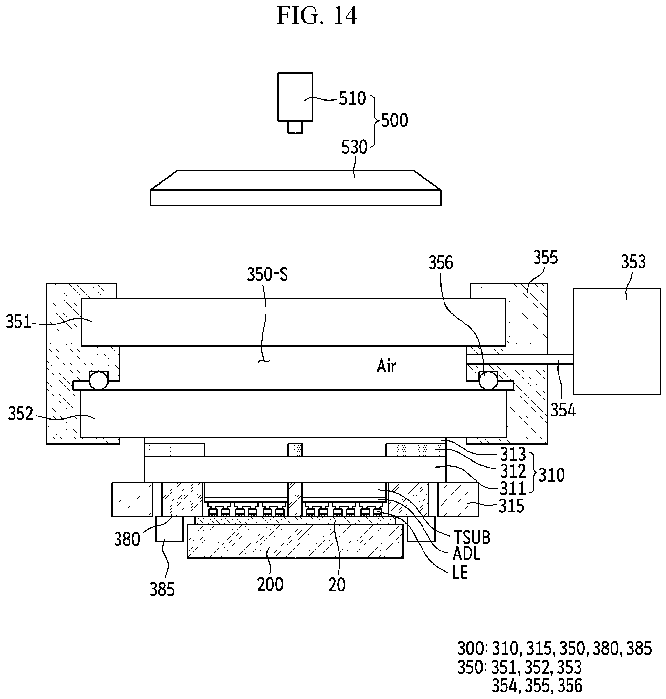

Referring to FIG. 14, the pressing member 350 is disposed on the front side of the mask member 310 and may move toward the display substrate 20 to come closer to the display substrate 20.

Fourth, gas may be supplied between the first light transmitting plate 351 and the second light transmitting plate 352 of the pressing member 350, and the laser is irradiated. (S140 in FIG. 11)
The gas pressure regulator 353 opens the gas valve and fills the sealed space 350-S between the first light transmitting plate 351 and the second light transmitting plate 352 with gas through the gas conduit 354. As the gas is filled into the sealed space 350-S, the pressure inside the sealed space 350-S increases, so that the second light transmitting plate 352 expands downward a direction, e.g. toward the display substrate 20, thereby generating a downward pressurizing force.

The second light transmitting plate 352 may move in the downward direction by the gas filling, and a uniform pressure may be applied to the surface of the light emitting element LE disposed on the display substrate 20. On the other hand, when the first light transmitting plate 351 presses the display substrate 20 on the mask member 310 without the second light transmitting plate 352, thermal deformation may occur in the first light transmitting plate 351 due to the irradiation of the laser light, which may deteriorate the uniformity of the pressing of the display substrate 20.

The laser irradiation portion 500 irradiates laser light toward the mask member 310 on the lower surface. Here, the light irradiated from the laser irradiation portion 500 penetrates through the opening 312-OS defined by the light blocking pattern layer 312 and the opening 380-OS of the support member 380 and is applied to the plurality of light emitting elements LE disposed on the display substrate 20. That is, only the laser light that has penetrated the opening 312-OS and the opening 380-OS may be applied to the plurality of light emitting elements LE disposed on the display substrate 20.

The laser light applied to the light blocking pattern layer 312 is not allowed to penetrate the light blocking pattern layer 312. Therefore, damage to the display substrate 20 that may occur due to the laser light being irradiated to an area NDA other than the donor substrate TSUB where bonding is unnecessary may be prevented.

When the laser irradiation is completed by the laser irradiation portion 500, the gas pressure regulator 353 may discharge the gas in the sealed space 350-S to lower the pressure in the sealed space 350-S. When the pressure in the sealed space 350-S is lowered, the second light transmitting plate 352 that has expanded downward returns to its original state, thereby reducing the pressurizing force.

Afterwards, the plate transfer member 320 may move the first light transmitting plate 351 away from the display substrate 20.

According to one embodiment, even in the case of a large area display substrate, even pressure distribution is possible when bonding the light emitting element LE on the display substrate 20 using a laser.

In addition, even in the case of the display substrate 20 with a large area, the support member 380 may support the second light transmitting plate 352 to an outer side of the display substrate 20 to provide a uniform pressurizing force on the display substrate 20.

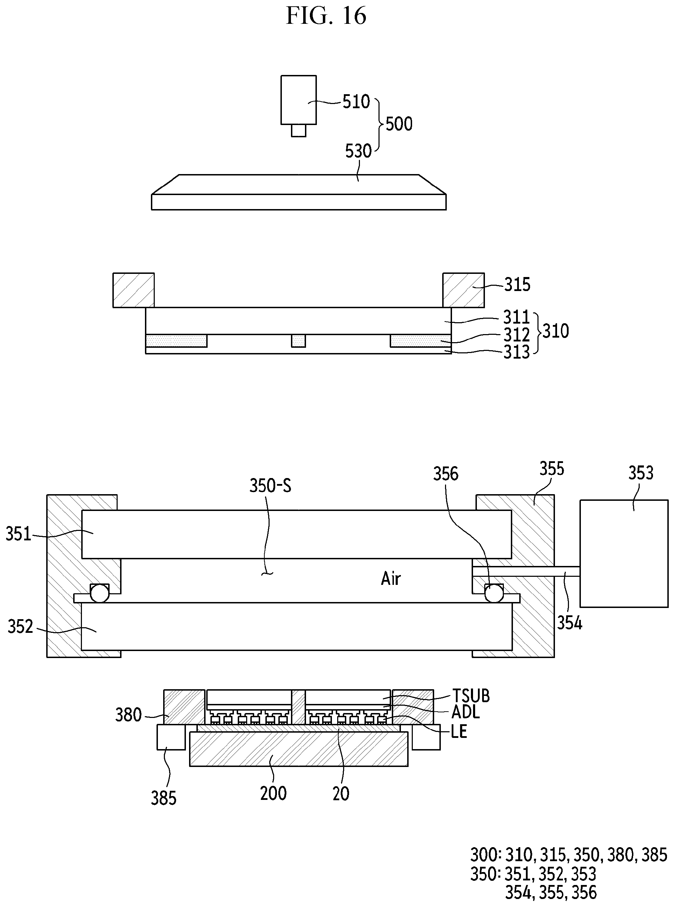

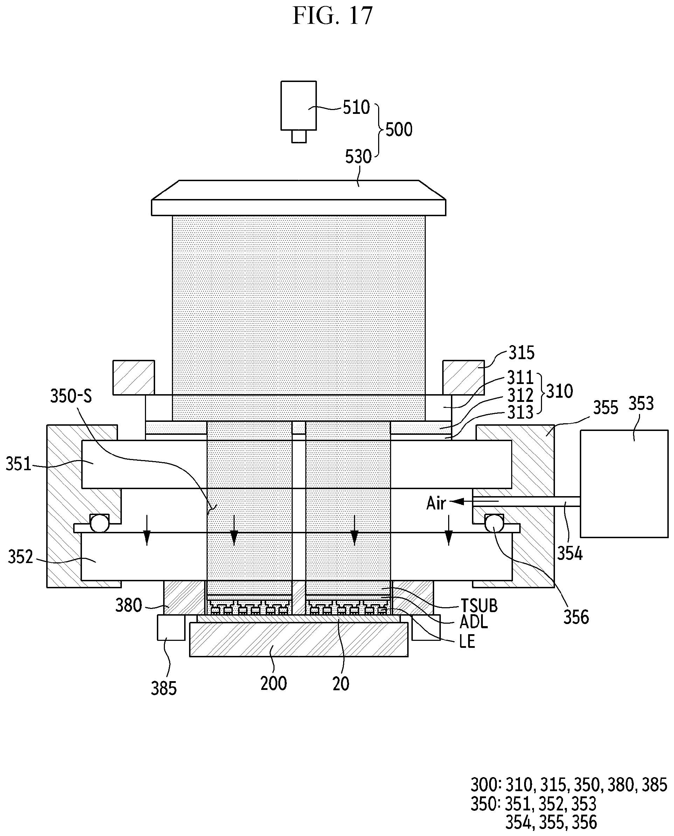

FIG. 16 is a side cross-sectional view schematically illustrating a display panel manufacturing device according to another embodiment. FIG. 17 is a side cross-sectional view schematically illustrating a micro LED transfer method using the display panel manufacturing device of FIG. 16.

Referring to FIGS. 16 and 17, the mask member 310 may be positioned between the pressing member 350 and the laser irradiation portion 500, which is different from the manufacturing device of the display panel described with reference to FIGS. 7 to 15. The description overlapping with the embodiment of FIGS. 7 to 15 will be omitted.

Referring to FIG. 16, the mask member 310 may be formed of a plurality of layers. The mask member 310 may include a base layer 311 and a light blocking pattern layer 312. Also, the mask member 310 may further include a protective layer 313 on the light blocking pattern layer 312, but the protective layer 313 may be omitted.

The base layer 311 may be disposed to face the laser irradiation portion 500. The base layer 311 is formed in the form of transparent or translucent flat plate, including at least one transparent material such as glass, quartz, silicon, or the like. The base layer 311 allows the laser light to be transmitted to the front or back surface in the opposite direction.

The base layer 311 may have a width that may cover the entire display substrate 20 on a plane.

The light blocking pattern layer 312 may be disposed on one side of the base layer 311 and includes a pattern having light blocking properties. The light blocking pattern layer 312 is disposed on the back of the base layer 311 and may be disposed to face the pressing member 350. The thickness of the light blocking pattern layer 312 may not be particularly limited but may have a film thickness within the range of 80 nm to 180 nm and for example of at least 80 nm, 90 nm, 100 nm, 110 nm, 120 nm, 130 nm, 140 nm, 150 nm, 160 nm, 170 nm or up to 180 nm. If it is too thin, it may become difficult to obtain the desired light blocking properties, and if it is too thick, it may become difficult to process the light blocking pattern with high precision.

The light blocking pattern layer 312 may not be particularly limited as long as it is a material having light blocking properties, but may include, for example, chromium (Cr), chromium oxynitride (CrON), chromium nitride (CrN), molybdenum silicide oxide (MoSiO), molybdenum silicide oxynitride (MoSiON), tantalum oxide (TaO), tantalum silicide oxide (TaSiO), and the like. In one embodiment, chromium (Cr) is selected for the light blocking pattern layer 312.

The light blocking pattern layer 312 may include a plurality of openings 312-OS. A laser light may penetrate through the plurality of openings 312-OS. Therefore, the plurality of openings 312-OS may define a transmission area of the laser light. Here, light irradiated from the laser irradiation portion 500 may be transmitted through the plurality of openings 312-OS of the light blocking pattern layer 312 and applied to the plurality of light emitting elements LE disposed on the display substrate 20.

If the light blocking pattern layer 312 should be too far from the light emitting element LE, diffraction of light may occur at the boundary of the opening 312-OS, which may cause an error between the opening 312-OS and the transmission area of the laser light.

The protective layer 313 may be disposed on one surface of the base layer 311 on which the light blocking pattern layer 312 may be provided, thereby protecting the surface of the light blocking pattern layer 312 and preventing damage to the light blocking pattern. The thickness of the protective layer 313 may not be particularly limited but may have a film thickness within a range of about 2 to 3 µm, e.g. at least about 2.0 µm, 2.2 µm, 2.4 µm, 2.6 µm or 2.8 µm, or up to about 3.0 µm . The protective layer 313 may be a transparent or translucent material, such as a transparent resin, including a transparent material.

The first mounting member 315 may be bonded to one surface of the outer surface of the mask member 310. For example, the first mounting member 315 may be bonded to the entire surface of the outer surface of the protective layer 313. The first mounting member 315 may be, for example, any one of an electrostatic chuck, an adhesive chuck, a vacuum chuck, and a porous vacuum chuck. Additionally, the first mounting member 315 may be a clamp but is not limited thereto. The first mounting member 315 may not overlap with the path of the laser light in a plan view.

Referring to FIG. 17, the gas pressure regulator 353 may open the gas valve to fill the sealed space 350-S between the first light transmitting plate 351 and the second light transmitting plate 352 with gas through the gas conduit 354. As the gas is filled in the sealed space 350-S, the pressure inside the sealed space 350-S may increase, causing the volume to expand in the downward direction, i.e., toward the display substrate 20, thereby generating a downward pressurizing force.

The second light transmitting plate 352 may move downward due to the gas filling, and a uniform pressure may be applied to the surface of the light emitting element LE disposed on one surface of the donor substrate TSUB.

The laser irradiation portion 500 irradiates laser light toward the first light transmitting plate 351 on the lower surface. Here, the light irradiated from the laser irradiation portion 500 penetrates the openings 312-OS defined by the light blocking pattern layer 312, the first light transmitting plate 351, the second light transmitting plate 352, and the openings 380-OS of the support member 380 and is applied to the plurality of light emitting elements LE of the donor substrate TSUB. That is, only laser light penetrated the opening 312-O corresponding to the donor substrate TSUB may be applied to the plurality of light emitting elements LE.

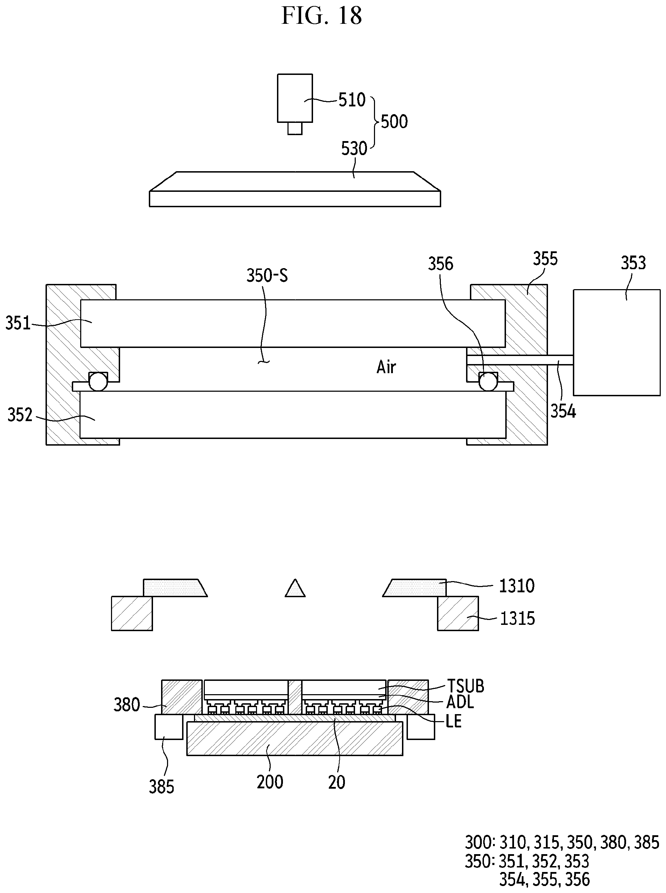

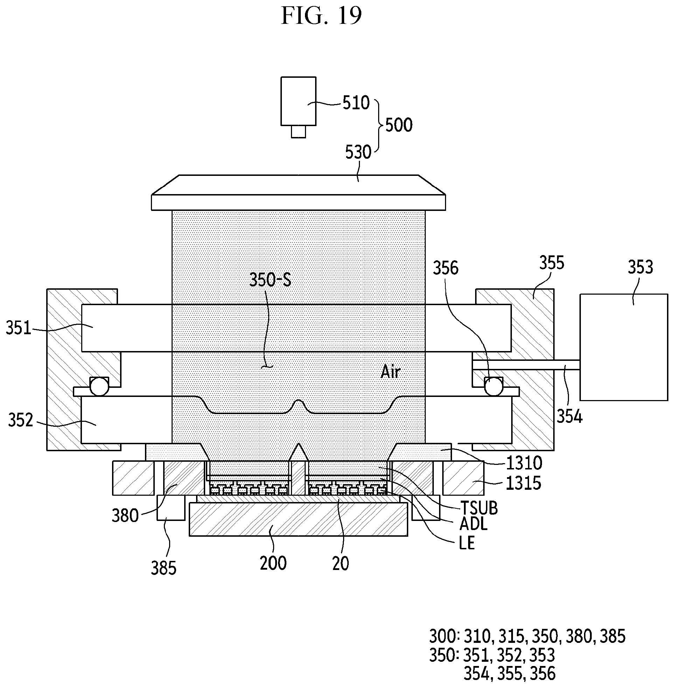

FIG. 18 is a side cross-sectional view schematically illustrating a display panel manufacturing device according to still another embodiment. FIG. 19 is a side cross-sectional view schematically illustrating a micro LED transfer method using the display panel manufacturing device of FIG. 18.

Referring to FIGS. 18 and 19, the pressing portion 300 is different from the device for manufacturing the display panel described with reference to FIGS. 7 to 15 in that the pressing portion 300 includes a metal mask 1310 instead of a light blocking pattern layer 312. The description overlapping with the embodiment of FIGS. 7 to 15 will be omitted.

Referring to FIGS. 18 and 19, the pressing portion 300 may include a metal mask 1310, a first mounting member 1315, a pressing member 350, a support member 380, and a second mounting member 385.

The metal mask 1310 may be an open mask including a pattern having light blocking properties. For example, the metal mask 1310 may be disposed between the pressing member 350 and the support member 380.

The metal mask 1310 may not be particularly limited as long as it is a material that reflects laser light, but may be a metal material such as aluminum, for example. For example, the metal mask 1310 may be a fine metal mask including a pattern having light blocking properties.

The metal mask 1310 may define openings 1310-OS that overlap with the openings 380-OS of the support member 380 in a plan view.

The metal mask 1310 may have a slope on the side of the openings 1310-OS. The widths of the upper and lower portions of the openings 1310-OS of the metal mask 1310 may be different from each other. For example, the width of the openings 1310-OS of the metal mask 1310 may become wider in a direction toward the pressing member 350.

The pressing member 350 may be disposed on the front side of the metal mask 1310 and may move toward the display substrate 20 to come closer to the display substrate 20.

The metal mask 1310 may have a wider area than the range of the laser irradiated from the laser irradiation portion 500. The metal mask 1310 may define a plurality of openings 1310-OS therein. The laser light may pass through the openings 1310-OS. Therefore, the openings 1310-OS may define a transmission area of the laser light. Here, the laser light irradiated from the laser irradiation portion 500 passes through the transmission area defined by the metal mask 1310 and may be applied to a plurality of light emitting elements LE disposed on one side of the donor substrate TSUB.

The first mounting member 1315 may be bonded to one side of the outer surface of the metal mask 1310. For example, the first mounting member 1315 may be disposed on the front side of the outer surface of the metal mask 1310. The first mounting member 1315 may include, but is not limited to, one of an electrostatic chuck, an adhesive chuck, a vacuum chuck, or a porous vacuum chuck. For example, the first mounting member 1315 may be a clamp. The first mounting member 1315 may not overlap with the path of the laser light in a plan view.

The pressing member 350 may be disposed on the front side of the metal mask 1310 and may move in a direction closer to the display substrate 20 (i.e., downward direction).

The pressing member 350 may include a first light transmitting plate 351, a second light transmitting plate 352, a gas pressure regulator 353, a gas conduit 354, and a holding frame 355.

The gas pressure regulator 353 opens a gas valve to fill a sealed space 350-S between the first light transmitting plate 351 and the second light transmitting plate 352 with gas through the gas conduit 354.

As the gas is filled into the sealed space 350-S, the pressure inside the sealed space 350-S increases, causing the second light transmitting plate 352 to expand downwardly, i.e., toward the display substrate 20, thereby generating a downward pressure.

The second light transmitting plate 352 may be moved in the downward direction by the gas filling, generating a pressurizing force in the downward direction.

The second light transmitting plate 352 may be formed of an elastic material, such as a silicon multilayer, a silicon-polyethylene terephthalate (PET) laminated layer, or polydimethylsiloxane (PDMS). When the second light transmitting plate 352 is formed of an elastic material, the second light transmitting plate 352 may expand in a downward direction by the gas filling. Accordingly, the second light transmitting plate 352 may have a concave shape along the openings 1310-OS of the metal mask 1310. For example, the area overlapping the openings 1310-OS of the metal mask 1310 may be relatively concave downward, and the area overlapping the pattern between the openings 1310-OS may be relatively convex upward.

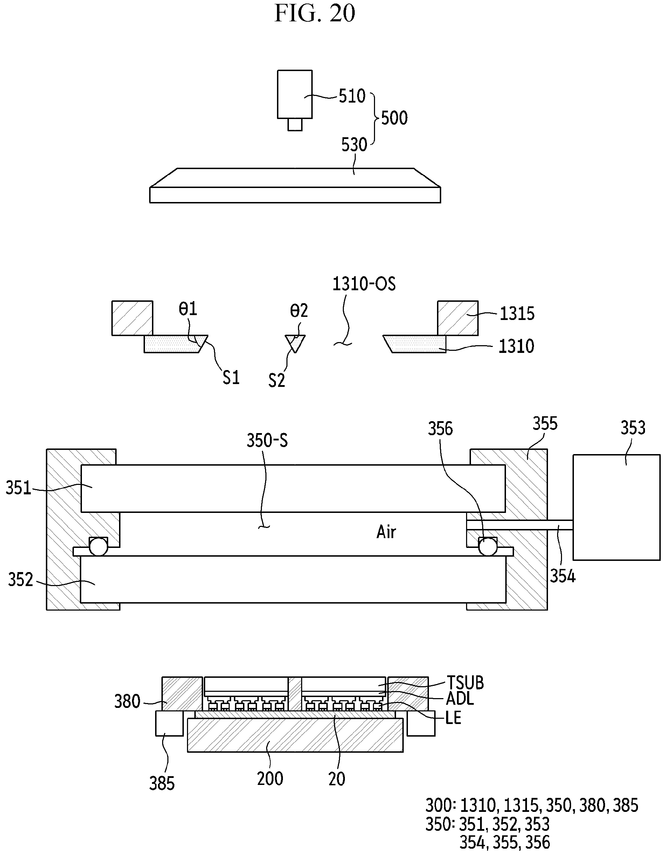

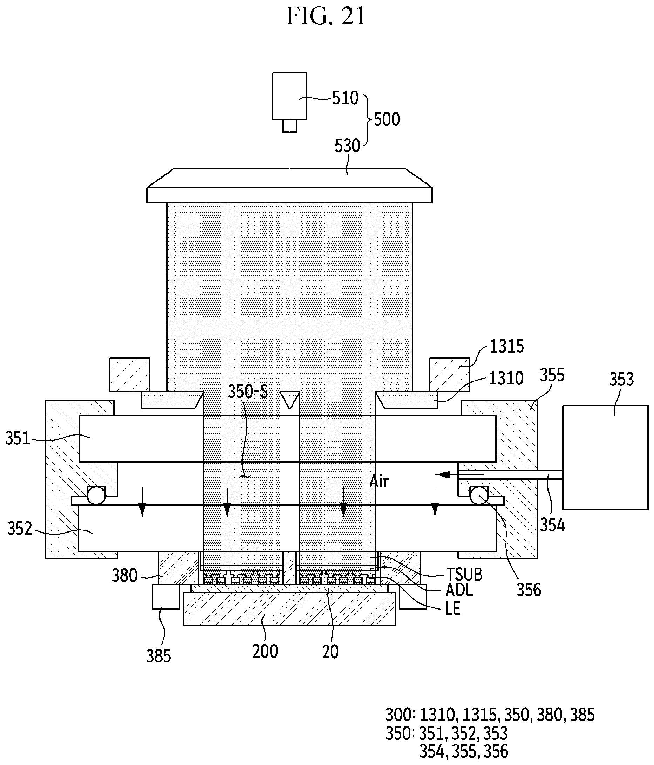

FIG. 20 is a cross-sectional view schematically illustrating a manufacturing device for a display panel according to yet another embodiment. FIG. 21 is a cross-sectional view illustrating a micro LED transfer method using the manufacturing device for the display panel of FIG. 20.

Referring to FIGS. 20 and 21, the device for manufacturing the display panel described with reference to FIGS. 18 and 19 differs from the device for manufacturing the display panel described with reference to FIGS. 18 and 19 in that the metal mask 1310 is disposed between the pressing member 350 and the laser irradiation portion 500. The description overlapping with the embodiment of FIGS. 18 and 19 is omitted.

The opening 1310-OS of the metal mask 1310 may be disposed so that the opening becomes narrower in a direction away from the pressing member 350.

The first angle θ1 formed by the first side S1 of the opening 1310-OS of the metal mask 1310 and the second angle θ2 formed by the second side S2 of the opening 1310-OS may be the same. The first angle θ1 formed by the first side S1 of the metal mask 1310 and the second angle θ2 formed by the one side and the second side S2 of the metal mask 1310 may be equal to each other as an obtuse angle exceeding 90 degrees. For example, the opening of the metal mask 1310 may be an equilateral trapezoid.

In another embodiment, the first side S1 and the second side S2 of the opening 1310-OS of the metal mask 1310 may be an obtuse angle exceeding 90 degrees, but the slope may have a curvature in another embodiment. The slope may become gentler in direction toward the pressing member 350, but the invention is not limited thereto.

Although embodiments of the present disclosure have been described above with reference to the attached drawings, a person skilled in the art to which the present disclosure pertains will understand that the present disclosure may be implemented in other specific forms without changing its technical idea or essential features. Therefore, the embodiments described above should be understood in all respects as illustrative and not restrictive.

## Claims

1. A device for manufacturing a display panel comprising:
a support portion (200) on which a display substrate (20) is mounted;
a mask member (310) disposed on a front surface of the support portion (200) and defining a plurality of first openings (312-OS) corresponding to a transmission area of a laser light;
a support member (380) configured to be disposed on the display substrate (20) and defining a plurality of second openings (380-OS) formed in an area corresponding to a plurality of donor substrates (TSUB) disposed on the display substrate (20), respectively;
a pressing portion (300) including a pressing member (350) for pressing the support member (380) and the plurality of donor substrates (TSUB) disposed on the display substrate (20); and
a laser irradiation portion (500) disposed on an upper portion of the mask member (310) for irradiating the laser light to light emitting elements (LE) of the donor substrates (20),
wherein the support member (380) has a height (20-h) equal to a sum of a thickness (T-h) of each of the donor substrates (TSUB) and a height (L-h) of each of the light emitting elements (LE).

2. The device of claim 1, wherein the second openings (380-OS) overlap the first openings (312-OS) and the donor substrates (TSUB) in a plan view, and/or
wherein the support member (380) protrudes outwardly from the display substrate (20) in a plan view.

3. The device of claim 1 or 2, wherein the mask member (310) includes a base layer (311), which transmits the laser light, and a light blocking pattern layer (312) disposed on the base layer (311) and defining the first openings (310-OS, 312-O, 312-OS, 380-OS, 1310-OS).

4. The device of claim 3, wherein the mask member (310) is a photomask, and further includes a protective layer (313) disposed on the light blocking pattern layer (312).

5. The device of and of claims 1 to 4, wherein the pressing member (350) includes a first light transmitting plate (351) and a second light transmitting plate (352), which are disposed on the support member (380) and overlap each other in a thickness direction of the support portion (200) and between which a sealed space (350-S) is formed,
wherein the pressing member (350) further includes a gas pressure regulator (353) for controlling gas pressure in the sealed space (350-S) and a gas conduit (354) connected between the gas pressure regulator (353) and the sealed space (350-S).

6. The device of claim 5, wherein the second light transmitting plate (352) is configured to move downward when a gas pressure in the sealed space (350-S) increases.

7. The device of claim 6, further comprising:
a holding frame (355), which fixes opposite ends of the first light transmitting plate (351) and opposite ends of the second light transmitting plate (352); and
a buffer (356) disposed between the second light transmitting plate (352) and the holding frame (355).

8. The device of any of claims 4 to 7, wherein the base layer (311) is disposed closer to the display substrate (20) than the protective layer (313) is, or
wherein the base layer (311) is disposed closer to the laser irradiation portion (500) than the protective layer (313) is.

9. The device of any of claims 1 to 8, further comprising:
a first mounting member (315, 1315), which is fixed to a bottom or top surface of an outer portion of the mask member (310) and supports the mask member (310); and
a second mounting member (385), which is fixed to a bottom surface of an outer portion of the support member (380) and supports the support member (380).

10. The device of any of claims 1 to 9, wherein the mask member (310) is disposed between the support member (380) and the pressing member (350), or
wherein the mask member (310) is disposed between the pressing member (350) and the laser irradiating portion.

11. The device of any of claims 1 to 10, wherein the mask member (310) is a metal mask (1310) having reflective properties and defining the first openings (312-OS).

12. The device of claim 11, wherein the metal mask (1310) includes a first side and a second side facing the first side, and the first side and the second side defines each of the first openings (312-OS),
wherein a first angle formed by the first side and a top surface of the metal mask (1310) and a second angle formed by the top surface and the second side are the same such that each of the first openings (312-OS) has an equilateral trapezoidal shape in a cross-sectional view, or the first side and the second side have curvature.

13. The device of claim 5 to 12, wherein the first light transmitting plate (351) and the second light transmitting plate (352) are formed of a rigid material, and/or
wherein the first light transmitting plate (351) is formed of a rigid material, wherein the second light transmitting plate (352) is formed of an elastic material.

14. A method of manufacturing a display panel comprising:
arranging (S110) a display substrate (20) on a support portion (200);
disposing (S120) a plurality of donor substrates (TSUB) and a support member (380) on the display substrate (20), wherein the plurality of donor substrates (TSUB) are disposed in a plurality of second openings (380-OS) defined by the support member (380), respectively;
disposing (S130) a mask member (310) and a pressing member (350) on the plurality of donor substrates (TSUB);
pressing (S140) the donor substrates (TSUB) by the pressing member (350); and
irradiating (S140) laser light to light emitting elements (LE) of the donor substrates (TSUB) through a plurality of first openings (312-OS) defined by the mask member (310),
wherein the support member (380) has a height (20-h) equal to a sum of a thickness (T-h) of each of the donor substrates (TSUB) and a height (L-h) of each of the light emitting elements (LE).

15. The method of claim 14, wherein
the pressing member (350) comprises a first light transmitting plate (351) and a second light transmitting plate (352), which are disposed on the support member (380) and overlap each other in a thickness direction of the support portion (200),
wherein a sealed space (350-S) is formed between the first light transmitting plate (351) and the second light transmitting plate (352), and the pressing member (350) controls a gas pressure of the sealed space (350-S) to move the second light transmitting plate (352) downward to pressurize the donor substrates (20),
and/or wherein
the method further comprises disposing (S140) a laser irradiating portion on an upper portion of the mask member (310),
wherein in the irradiating of the laser light to the light emitting elements (LE) of the donor substrates (TSUB), a laser light passing through the first openings (312-OS) of the mask member (310) passes through the second openings (380-OS) of the support member (380) and is irradiated to the light emitting elements (LE) of the donor substrates (TSUC), and a laser light irradiated to an area other than the first openings (312-OS) of the mask member (310) is blocked.
